# EUROPEAN PATENT APPLICATION

(11) **EP 4 697 878 A1**
(43) Date of publication of application: **18.02.2026**
(21) Application number: 24788914.0
(22) Date of filing: 18.03.2024
(51) Int. Cl.: H05K 7/20, H01Q 1/02

(54) **HEAT DISSIPATION DEVICE, HEAT DISSIPATION MODULE, AND ANTENNA DEVICE COMPRISING SAME**

(30) Priority: 11.04.2023 KR 20230047392; 15.03.2024 KR 20240036130
(71) Applicant: KMW Inc., Hwaseong-si, Gyeonggi-do 18462 (KR)
(72) Inventor: KIM, Duk Yong, Yongin-si Gyeonggi-do 17086 (KR); JI, Kyo Sung, Hwaseong-si Gyeonggi-do 18484 (KR); PARK, Min Sik, Hwaseong-si Gyeonggi-do 18376 (KR); RYU, Chi Back, Hwaseong-si Gyeonggi-do 18392 (KR); YANG, Jun Woo, Suwon-si Gyeonggi-do 16694 (KR); KIM, Hye Yeon, Hwaseong-si Gyeonggi-do 18496 (KR); CHOI, In Hwa, Yongin-si Gyeonggi-do 17148 (KR); SEO, Jin Kook, Busan 46726 (KR)
(74) Representative: impuls legal PartG mbB
(86) International application number: PCT/KR2024/003338
(87) International publication number: WO 2024/214971

(57) **Abstract**

Provided are a heat dissipation device, a heat dissipation module, and an antenna apparatus including the same. The heat dissipation device includes heat receiving parts that collect heat generated from heating substances, and a heat discharging part that exchanges heat collected from the heating substances with outside air, wherein at least one of the heat receiving parts is coupled through a heat collection part, and is coupled to a housing body provided with the heating substances. The heat collection part includes: a heat transfer member for coupling formed with a plurality of fixed slits into which a part of at least one of the heat receiving parts is inserted; and a shielding cover coupled to the heat transfer member for coupling to form a predetermined refrigerant-filled space therein, and sealing the refrigerant-filled space.

## Description

### [Technical Field]

The present disclosure relates to a heat dissipation device, a heat dissipation module, and an antenna apparatus including the same, and more specifically, to a heat dissipation device, a heat dissipation module, and an antenna apparatus including the same, which can improve heat dissipation performance of an electronic device including the antenna apparatus and generating significant heat during operation.

### [Background Art]

A wireless communication technology, for example, a multiple input multiple output (MIMO) technology is a technology of dramatically increasing a data transmission capacity by using a plurality of antennas, and a spatial multiplexing technique in which a transmitter transmits different data through respective transmit antennas and a receiver distinguishes transmitted data through appropriate signal processing.

Accordingly, as the number of transmit antennas and the number of receive antennas are simultaneously increased, a channel capacity increases, so that more data can be transmitted. For example, increasing the number of antennas to 10 secures about 10 times the channel capacity by using the same frequency band compared to the current single antenna system.

4G LTE-advanced uses up to 8 antennas, and a pre-5G product with 64 or 128 antennas has already been developed. 5G is using base station equipment with a larger number of antennas, which is called a massive MIMO technology. While the current cell operation is two-dimensional, the introduction of the massive MIMO technology enables three-dimensional beamforming, which is also called a full dimension (FD-MIMO).

In the massive MIMO technology, as the number of antennas increases, the number of transmitters and the number of filters also increase.

However, there is an increased demand for reducing the weight and volume of an electronic device such as a radio unit (RU) in consideration of spatial constraints of the installation site, and simultaneously, there is also an increased demand for high-power Rus with transmission power of 320 W or 640 W for coverage expansion of massive MIMO. However, the weight and volume of a heat dissipation device are inevitably increased in order to cope with power consumed by and the amount of heat generated by high-power RF components (for example, power amplifiers), thereby having an adverse effect on the reduction of the weight and size of an electronic device such as RU.

In particular, recently, in electrically-driven electronic devices and the like as well as antenna apparatuses, research is being actively conducted to efficiently cool operating system heat in order to prevent explosions due to overheating while optimizing the performance thereof.

However, in order to easily exchange the operating system heat with the outside air, a structure is adopted to dissipate heat by moving heat from an internal heating element (heating substance) to an external material with high thermal conductivity as much as possible and then exchanging heat with the outside air, but there is a problem of facing the limitations of the thermal conductivity of the material itself of a cooling medium.

In this regard, recently, active research is underway to separate an antenna unit and reduce the weight of the antenna unit, which is subjected to tilting or steering, in order to adjust the radiation direction of a radiation beam at an installation site of an antenna apparatus, to mainly place a heating substance at a radio unit (RU) fixed to a fixed structure such as a support pole, and to improve heat dissipation performance.

### [Disclosure]

### [Technical Problem]

The present disclosure is directed to providing a heat dissipation device, a heat dissipation module, and an antenna apparatus including the same, which can improve on-site workability by preventing an increase in the weight of an antenna unit requiring directivity adjustment while effectively dissipating heat generated from an electronic device such as an antenna apparatus.

In addition, the present disclosure is directed to providing a heat dissipation device, a heat dissipation module, and an antenna apparatus including the same, which overcome limitations in an increase in a heat dissipation surface area due to thermal conductivity of a material itself and enable design of various types of heat dissipation structures.

In addition, the present disclosure is directed to providing a heat dissipation device, a heat dissipation module, and an antenna apparatus including the same, which can improve the productivity of products by performing coupling and refrigerant sealing between a heat collection part and a heat receiving part through a simple process.

Objects of the present disclosure are not limited to the above-described objects, and other objects that are not mentioned will be able to be clearly understood by those skilled in the art from the following description.

### [Technical Solution]

In order to achieve the objects, a heat dissipation device according to an embodiment of the present disclosure includes: heat receiving parts that collect heat generated from heating substances; and a heat discharging part that exchanges heat collected from the heating substances with outside air, wherein at least one of the heat receiving parts is coupled through a heat collection part, and is coupled to a housing body provided with the heating substances, and the heat collection part includes: a heat transfer member for coupling formed with a plurality of fixed slits into which a part of at least one of the heat receiving parts is inserted; and a shielding cover coupled to the heat transfer member for coupling to form a predetermined refrigerant-filled space therein, and sealing the refrigerant-filled space.

The heat transfer member for coupling and the shielding cover seal the refrigerant-filled space when joining is performed by a brazing welding method in a state in which the part of at least one of the heat receiving parts is inserted into the plurality of fixed slits.

The joining may be performed using any one of a brazing welding method and a laser welding method.

The heat collection part may further include a plurality of support pins each having one end supported by the shielding cover and the other end supported between adjacent fixed slits among the plurality of fixed slits adjacent to each other.

The filler metal may be applied to the heat transfer member for coupling along an inner end of the fixed slit, may flow in a direction of gravity when joining is performed by the brazing welding method, and may seal a gap between the fixed slit and an outer side of the heat receiving part.

The heat transfer member for coupling may be provided with a plurality of rigid reinforcing dot portions protruding toward the shielding cover along a gap between the fixed slits, the shielding cover may be provided with a plurality of welding dot portions that protrude toward the heat transfer member for coupling at locations corresponding to the plurality of rigid reinforcing dot portions, and during joining by the brazing welding method, the plurality of rigid reinforcing dot portions and the plurality of welding dot portions may be joined together by a filler metal applied to the plurality of rigid reinforcing dot portions.

The filler metal may further be applied along a rim end of the heat transfer member for coupling in addition to the fixed slit or the rigid reinforcing dot portion.

The filler metal may be provided in a paste type or an alloy type with nickel as a main component.

The filler metal may be applied in advance to an inner end of the fixed slit in a state in which a part of the heat receiving part is inserted into the fixed slit.

A heat dissipation module according to an embodiment of the present disclosure includes: a heat dissipation device including heat receiving parts that collect heat generated from heating substances and a heat discharging part that exchanges heat collected from the heating substances with outside air; and a heat collection part including a heat transfer member for coupling having one surface formed with a board receiving part for accommodating a PA board and the other surface formed with a plurality of fixed slits for installing the heat dissipation device, the heat transfer member for coupling being filled with phase-changeable refrigerant, wherein the heat collection part includes: a heat transfer member for coupling formed with a plurality of fixed slits into which a part of at least one of the heat receiving parts is inserted; and a shielding cover coupled to the heat transfer member for coupling to form a predetermined refrigerant-filled space therein, and sealing the refrigerant-filled space.

The heat transfer member for coupling and the shielding cover seal the refrigerant-filled space when joining is performed by a brazing welding method in a state in which the part of at least one of the heat receiving parts is inserted into the plurality of fixed slits.

The filler metal may be applied to the heat transfer member for coupling along an inner end of the fixed slit, may flow in a direction of gravity when joining is performed by the brazing welding method, and may seal a gap between the fixed slit and an outer side of the heat receiving part.

The heat transfer member for coupling may be provided with a plurality of rigid reinforcing dot portions protruding toward the shielding cover along a gap between the fixed slits, the shielding cover may be provided with a plurality of welding dot portions that protrude toward the heat transfer member for coupling at locations corresponding to the plurality of rigid reinforcing dot portions, and during joining by the brazing welding method, the plurality of rigid reinforcing dot portions and the plurality of welding dot portions may be joined together by a filler metal applied to the plurality of rigid reinforcing dot portions.

The filler metal may be applied in advance to an inner end of the fixed slit in a state in which a part of the heat receiving part is inserted into the fixed slit.

An antenna apparatus according to an embodiment of the present disclosure includes: a housing body formed with an installed space where an RF filter unit is installed; and a heat dissipation module coupled to a front portion or a rear portion of the housing body, wherein the heat dissipation module includes: a heat dissipation device including heat receiving parts that collect heat generated from heating substances and a heat discharging part that exchanges heat collected from the heating substances with outside air; and a heat collection part including a heat transfer member for coupling having one surface formed with a board receiving part for accommodating a PA board and the other surface formed with a plurality of fixed slits for installing the heat dissipation device, the heat transfer member for coupling being filled with phase-changeable refrigerant, and the heat collection part includes: a heat transfer member for coupling formed with a plurality of fixed slits into which a part of at least one of the heat receiving parts is inserted; and a shielding cover coupled to the heat transfer member for coupling to form a predetermined refrigerant-filled space therein, and sealing the refrigerant-filled space.

The housing body may include: a center housing formed with the installation space where the RF filter unit is installed; a front heat dissipation housing coupled to a front portion of the center housing; and a rear heat dissipation housing coupled to a rear portion of the center housing, wherein the heat dissipation module may include a front heat dissipation module installed at the front heat dissipation housing and a rear heat dissipation module installed at the rear heat dissipation housing, and the front heat dissipation housing and the rear heat dissipation housing may each be formed with a plurality of module coupling grooves that facilitate coupling of the front heat dissipation module and the rear heat dissipation module.

When the heat receiving part is disposed to overlap a front portion or a rear portion of the housing body in a front-rear direction, the heat discharging part of each of the front heat dissipation module and the rear heat dissipation module may extend upward beyond an upper end of the housing body, and extend to occupy at least a part of a heat exchange region corresponding to a direct upper part of the housing body in a front-rear thickness direction.

An upper end of the housing body may further include a guide panel formed with a plurality of guide slits into which upper ends of the heat dissipation devices of the front heat dissipation module and the rear heat dissipation module are inserted.

### [Advantageous Effects]

In accordance with a heat dissipation device, a heat dissipation module, and an antenna apparatus including the same according to an embodiment of the present disclosure, on-site workability can be improved by effectively dissipating heat generated from an electronic device including the antenna apparatus and preventing an increase in the overall weight of a product.

In addition, in accordance with a heat dissipation device, a heat dissipation module, and an antenna apparatus including the same according to an embodiment of the present disclosure, limitations in thermal conductivity of a material itself can be overcome, and expansion of a product size can be suppressed in design of increasing a heat dissipation surface area.

In addition, in accordance with a heat dissipation device according to an embodiment of the present disclosure, the productivity of products can be improved by performing coupling and refrigerant sealing between a heat collection part and a heat receiving part through a simple process.

### [Description of Drawings]

FIGS. 1A and 1B are front and rear perspective views showing an example of an antenna apparatus including a heat dissipation device and a heat dissipation module according to an embodiment of the present disclosure.
FIG. 2 is a front view of FIGS. 1A and 1B.
FIG. 3 is a side view of FIGS. 1A and 1B.
FIGS. 4A and 4B are front and rear perspective views showing a state in which a rear clamping part is mounted.
FIGS. 5A and 5B are exploded perspective views showing the rear clamping part in FIGS. 4A and 4B.
FIG. 6 is a perspective view showing a state in which a side clamping part is mounted.
FIGS. 7A and 7B are entire exploded perspective views of FIGS. 1A and 1B.
FIG. 8 is an exploded perspective view of a finger guard panel assembly of components in FIG. 1A.
FIG. 9 is front and rear perspective views showing the arrangement state of the heat dissipation device according to an embodiment of the present disclosure.
FIGS. 10A and 10B are front and rear exploded perspective views of FIG. 9.
FIG. 11 is a perspective view showing the heat dissipation device according to an embodiment of the present disclosure.
FIGS. 12A and 12B are front and rear exploded perspective views for explaining a coupling process of a heat dissipation device according to another embodiment of the present disclosure.
FIG. 13 is an exploded cross-sectional view for explaining a coupling state with a heat collection part by a brazing welding method.
FIG. 14 is an exploded perspective view for explaining a coupling state with a heat collection part by a brazing welding method.
FIG. 15 is a perspective view showing a state in which the finger guard panel assembly of components in FIG. 8 is removed.
FIGS. 16A and 16B are front and rear exploded perspective views showing an exploded state of only a front heat dissipation module installed at a front portion of a housing body of components in FIG. 15 and combined with the heat dissipation device according to an embodiment of the present disclosure.
FIG. 17 is a cutaway perspective view taken along line A-A in FIG. 2.
FIG. 18 is a cross-sectional view taken along line A-A in FIG. 2, and is a cross-sectional view showing various implementation examples of heat dissipation devices and heat dissipation modules.
FIG. 19 is an exploded perspective view showing the installation state of a front heat dissipation housing, the heat dissipation device, and a front heat dissipation module to the center housing of components of FIG. 1.

### <Description of reference numerals>

1: Radio unit 10: Finger guard panel assembly
20: Rear installation bracket 20h-1: Screw coupling hole
25: Screw through hole 27: Clamp fixing screw
30: Clamping unit 30R: Rear clamping part
30S: Side clamping part 31: First fixed plate portion
32: Second fixed plate portion 33: Clamping bar
34: Stud bolt 35: Bolt guide rod
40: Guide panel 41: Guide slit
50: Heat exchange region 100: Housing body
110C: Center housing 110F: Front heat dissipation housing
110R: Rear heat dissipation housing 120: RF filter part
121: Filter body 122: Resonator
123: Filter tuning cover 124: Engraving portion
130F: Front board (PSU board) 130R: Rear board (PBA)
140A: Front board installation groove 140B: Rear board installation groove
200: Heat dissipation module 200A: Front heat dissipation module
200B: Rear heat dissipation module 205: Refrigerant flow space
210: Heat dissipation device 210-1: One-side heat conductive panel
210-2: Other-side heat conductive panel 210-F1: First refrigerant passage
210-F2: Second refrigerant passage 210-F3: Inclined guide
210-F4: Joining portion 211: Heat receiving part
212: Heat discharging part 220: Heat collection part
221: Heat transfer member for coupling 222: Shielding cover
222b: Welding dot part 223: PA board
230: Filler metal 230a: Inner filler metal
230b: Rim filler metal 230c: Filler metal for fixing slit

### [Mode for Invention]

Hereinafter, a heat dissipation device, a heat dissipation module, and an antenna apparatus including the same according to an embodiment of the present disclosure are described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as the terms generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

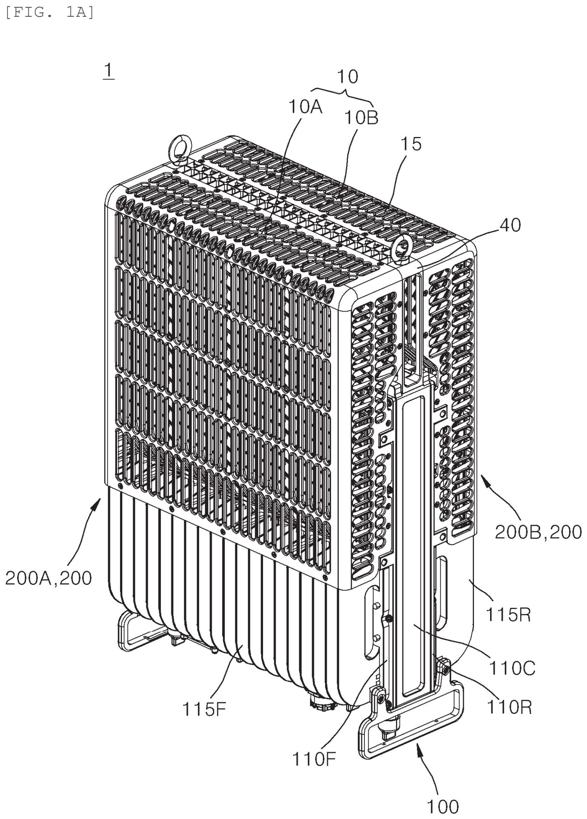

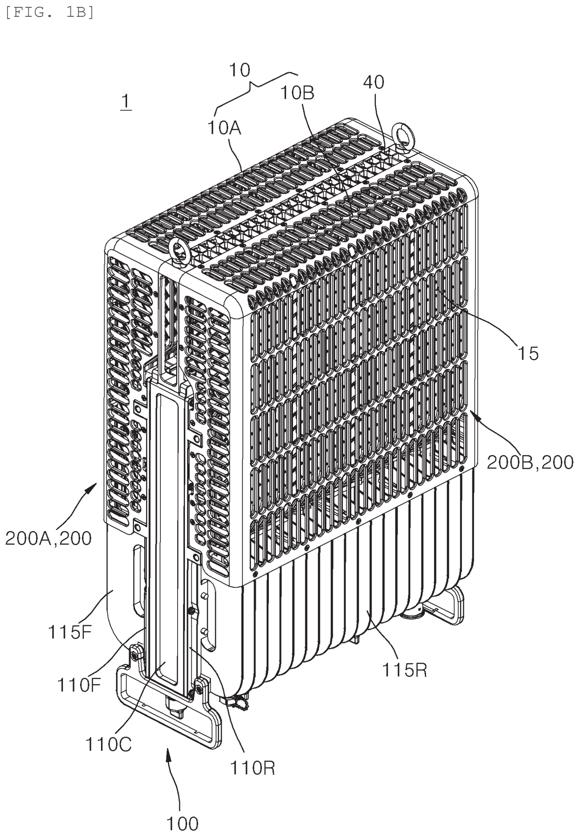

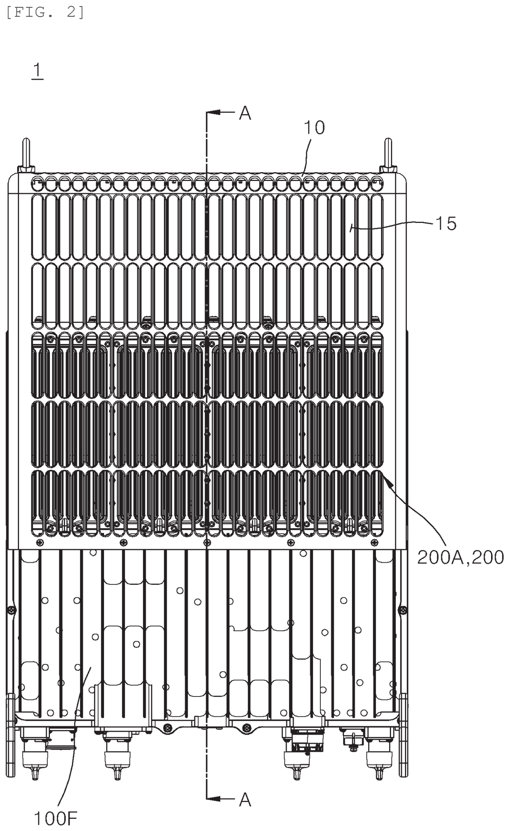

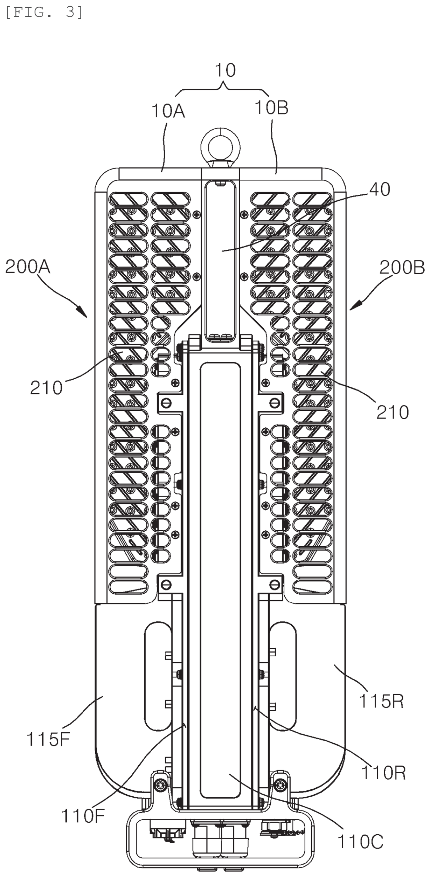

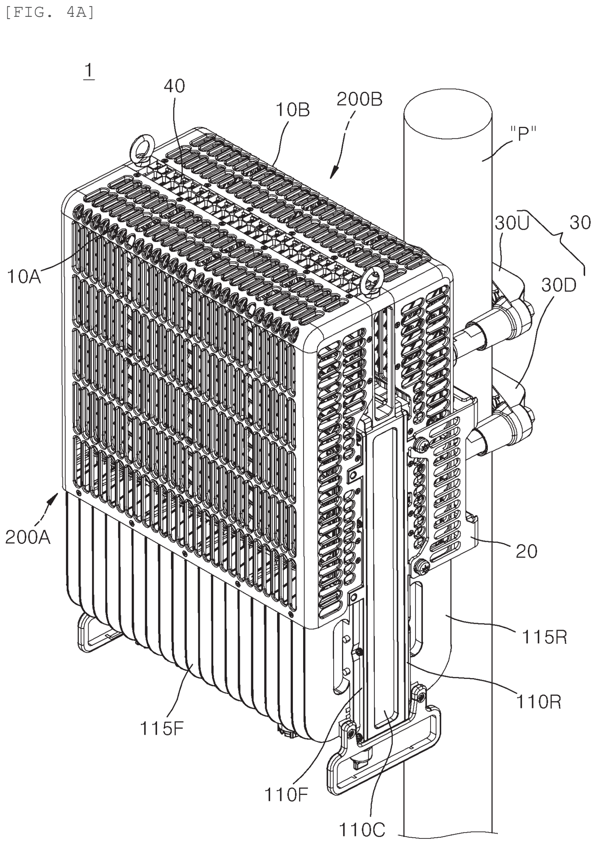

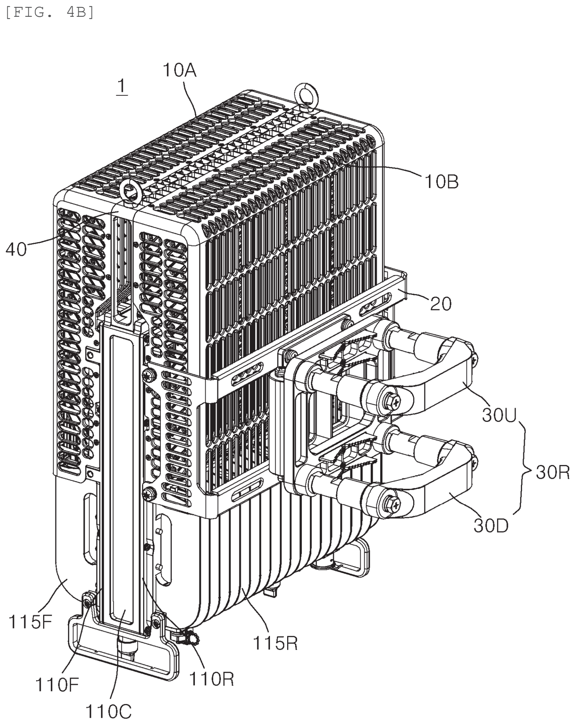

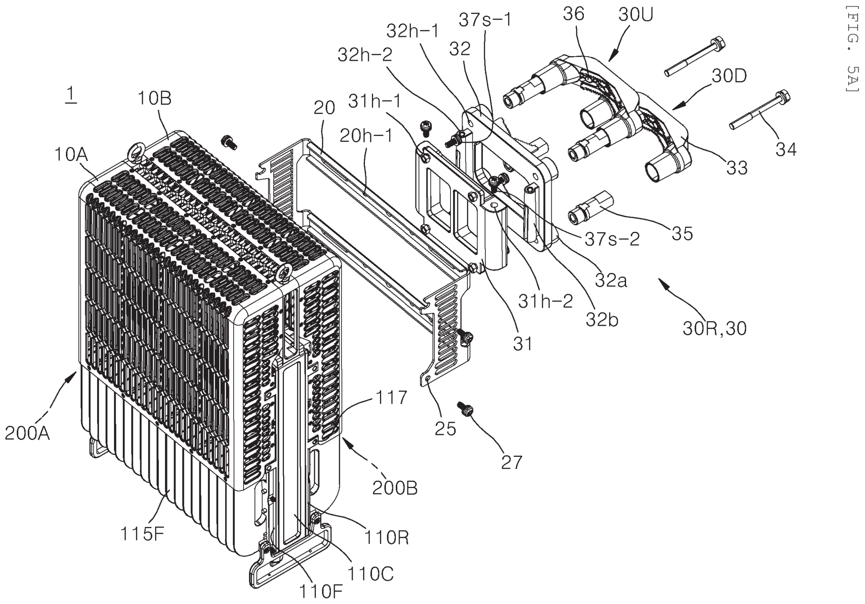

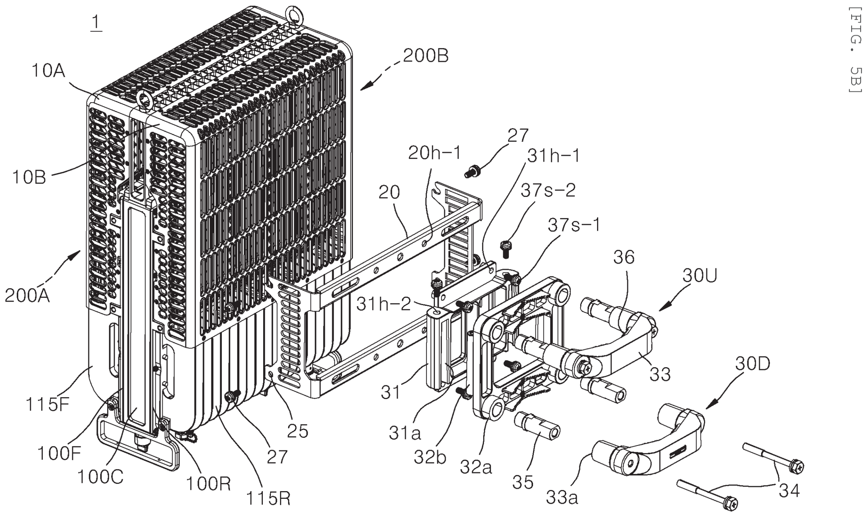

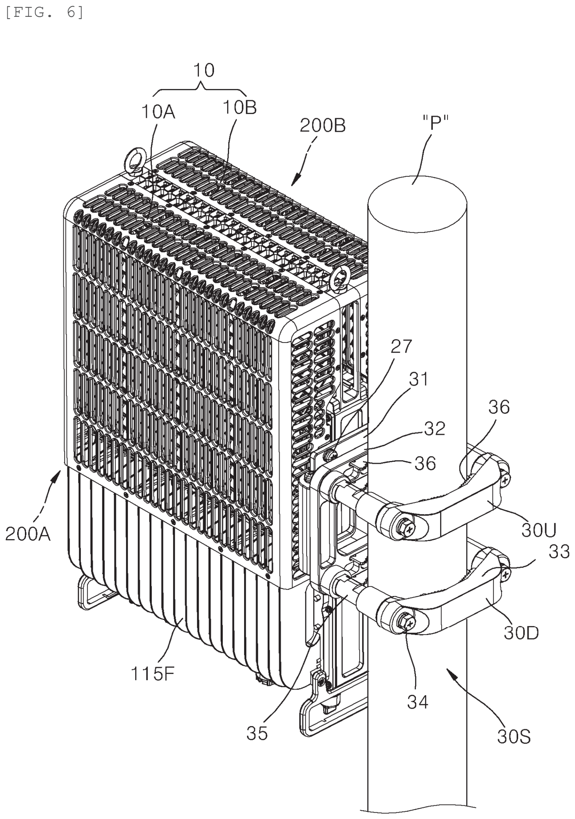

FIGS. 1A and 1B are front and rear perspective views showing an example of an antenna apparatus including a heat dissipation device and a heat dissipation module according to an embodiment of the present disclosure, FIG. 2 is a front view of FIGS. 1A and 1B, FIG. 3 is a side view of FIGS. 1A and 1B, FIGS. 4A and 4B are front and rear perspective views showing a state in which a rear clamping part is mounted, FIGS. 5A and 5B are exploded perspective views showing the rear clamping part in FIGS. 4A and 4B, and FIG. 6 is a perspective view showing a state in which a side clamping part is mounted.

As illustrated in FIGS. 1A and 1B, FIG. 2, FIG. 3, FIGS. 4A and 4B, FIGS. 5A and 5B, and FIG. 6, a heat dissipation device 210 according to an embodiment of the present disclosure is installed in a radio unit 1 that is an example of an electronic device and can perform a function of and dissipating heat by receiving the heat from a heating substance (not illustrated) installed within the radio unit 1 and operating to generate system heat.

The electronic device has a concept that encompasses any type of device with an internal configuration similar to the aforementioned heating substance. However, for convenience of explanation, an antenna apparatus (or the radio unit 1), which is a key product in the business of the applicant of the present disclosure, is described below as an application example of the present disclosure.

In particular, prior to describing an embodiment of the present disclosure, a combination of a plurality of heat dissipation devices 210 to be described below is defined as a "heat dissipation module 200", and a product installed with the plurality of heat dissipation devices 210 and a plurality of heat dissipation modules 200 is defined as an "antenna apparatus (or the radio unit 1)". However, the antenna apparatus 1 can be understood to refer only to a radio unit, excluding an antenna unit that is a collection of antenna radiating elements.

The representative type of electrically driven heating substance provided inside the electronic device includes semiconductors, but is not limited thereto, and does not exclude RF components of antenna apparatuses for communication, displays, energy storage systems (ESSs), artificial intelligence (AI), and internal driving elements of other electrical and electronic devices.

As the electronic device employing the heat dissipation device 210 according to an embodiment of the present disclosure, the radio unit 1 that is one of the antenna apparatuses is employed. As described below, a PA element 223a mounted on a PA board 223 is employed and described as a heating substance.

The radio unit 11 provided with the heat dissipation device 210 according to an embodiment of the present disclosure serves as a repeater in a base station antenna apparatus. By separating an antenna unit including antenna radiating elements that substantially form and radiate an antenna beam, the weight of a single product can be reduced to improve the on-site working environment.

Unlike the antenna unit (not illustrated), the radio unit 1 requires no tilting or steering adjustment for setting the direction of a radiation beam and requires only stable fixing to a structure such as a support pole P to be described below, thereby providing the advantage of making an antenna unit reflectively requiring installation at a higher location lightweight.

As illustrated in FIGS. 1A and 1B and FIG. 2, the radio unit 1 may further include a finger guard panel assembly 10 that surrounds the heat dissipation device 210 according to an embodiment of the present disclosure described below to prevent injuries such as burns to workers. The specific configuration and coupling structure of the finger guard panel assembly 10 are described below in more detail.

On the other hand, as illustrated in FIGS. 1A and 1B, FIG. 2, FIG. 3, FIGS. 4A and 4B, FIGS. 5A and 5B, and FIG. 6, the radio unit 1 may include an RF filter unit 120, a housing body 100 that facilitates fixing of the RF filter unit 120, and the heat dissipation device 210 according to an embodiment of the present disclosure coupled to the housing body 100.

As illustrated in FIGS. 4A and 4B, FIGS. 5A and 5B, and FIG. 6, the radio unit 1 can be stably mounted to the support pole P via a clamping unit 30.

As illustrated in FIGS. 4A and 4B and FIGS. 5A and 5B, the clamping unit 30 may include a rear clamping part 30R provided on a rear portion of the radio unit 1 to mount the radio unit 1 on the support pole P, and a side clamping part 30S provided on a side surface of the radio unit 1 to mount the radio unit 1 on the support pole P.

Since a rear portion of the housing body 100 is not exposed to the outside by the finger guard panel assembly 10, the rear clamping part 30R may be further provided with a rear installation bracket 20, thereby facilitating installation on the left and right sides of the housing body 100 that are also exposed to the outside by the finger guard panel assembly 10.

The side clamping part 30S can be directly coupled to either the left or right side of the housing body 100, which is exposed without being directly concealed by the finger guard panel assembly 10, without the aforementioned rear installation bracket 20.

As illustrated in FIG. 5A, the rear installation bracket 20 extends horizontally to be parallel to and spaced apart from the rear portion of the radio unit 1, with both ends bent forward. The rear installation bracket 20 can be fixed to the radio unit 1 by an operation in which clamp fixing screws 27 pass through screw through holes 25 formed at both ends of the rear installation bracket 20 and are fastened to screw fastening holes 117 formed on both left and right sides of the housing body 100.

Since the rear clamping part 30R and the side clamping part 30S are different from each other only in whether to include the aforementioned rear installation bracket 20 and have the same remaining configuration, only the rear clamping part 30R is described below in detail with reference to FIGS. 5A and 5B and the description of the side clamping part 30S is replaced with the description of the configuration of the rear clamping part 30R.

As illustrated in FIGS. 5A and 5B, the rear clamping part 30R may include a first fixed plate portion 31 fixed to the rear installation bracket 20, a second fixed plate portion 32 closely coupled to a rear portion of the first fixed plate portion 31, and a clamping bar 33 coupled to a pair of left and right boss portions 32a among four boss portions 32a formed at square corners of a rear portion of the second fixed plate portion 32 via a pair of stud bolts 34 and provided to surround the support pole P.

The first fixed plate portion 31 is manufactured to a single specification for installation on the rear installation bracket 20 provided on the rear portion of the radio unit 1 or on the side surface (in the case of the side clamping part 30S) of the radio unit 1, and can universally fix the second fixed plate portion 32 manufactured to various specifications to the radio unit 1 regardless of the size (diameter or the like) of the support pole P.

Unlike the first fixed plate portion 31 manufactured to a single specification, the second fixed plate portion 32 is manufactured to various specifications depending on the size (diameter or the like) of the support pole P to be installed, as described above, and can be selected according to the specifications of the support pole P and coupled to the first fixed plate portion 31.

At least one pair of screw through holes 31h-1 are formed at upper and lower ends of the first fixed plate portion 31, respectively, and the first fixed plate portion 31 can be fixed to the rear installation bracket 20 by an operation in which a plurality of assembly screws 37s-1 pass through the screw through holes 31h-1 and are fastened to screw fastening holes 20h-1 previously formed in the rear installation bracket 20.

The first fixed plate portion 31 is formed at the left and right ends of the rear portion thereof with form-fitting grooves 31a into which form-fitting ribs 32b protruding forward from the second fixed plate portion 32 are fitted, respectively. In a state in which the form-fitting ribs 32b are fitted into the form-fitting grooves 31b, respectively, the second fixed plate portion 32 can be firmly fixed to the first fixed plate portion 31 via plate assembly screws 37s-2.

To this end, a screw through hole 31h-2 through which the plate assembly screw 37s-2 passes can be formed in an upper end of the first fixed plate portion 31 where the form-fitting groove 31a is formed, and a screw fastening hole 32h-2 into which the plate assembly screw 37s-2 is fastened can be formed in the upper end of the form-fitting rib 32b of the second fixed plate portion 31.

Even when the second fixed plate portion 32 is manufactured in various specifications depending on the size of the support pole P, the aforementioned form-fitting rib 32b and form-fitting groove 31a are formed to have the same specifications, thereby enabling universal coupling of the first fixed plate portion 31 to the second fixed plate portions 32 having various specifications.

The clamping bar 33 may include an upper clamping bar 30U positioned at a relatively upper side and a lower clamping bar 30D positioned at a relatively lower side.

The upper clamping bar 30U and the lower clamping bar 30D are formed in an approximately "C" shape with one side open. The stud bolts 34 that surround one side of an outer peripheral surface of the support pole P and pass through both ends thereof in a front-rear direction can be bolt-fastened to bolt fastening bosses 32a formed at corner ends of the rear portion of the second fixed plate portion 32 via bolt guide rods 35 insertable into connecting bosses 33a provided at both ends of the clamping bar 33.

The upper and lower ends of the rear portion of the second fixed plate portion 32, the upper clamping bar 30U, and the lower clamping bar 30D can each be provided with clamping gears 36 that clamp the outer surface of the support pole P so that the degree of protrusion to the outside is adjusted.

The clamping gears 36 are each provided as a pair to be spaced vertically apart from each other, so that they can clamp four locations on the outer peripheral surface of at least one support pole P.

As illustrated in FIG. 6, as previously described above, the side clamping part 30S is different from the rear clamping part 30R in that, the configuration corresponding to the first fixed plate portion 31 is directly fastened to the screw fastening holes 117 formed on the left and right sides of the housing body 100 by using the clamp fixing screws 27, without an intermediary component such as the rear installation bracket 20.

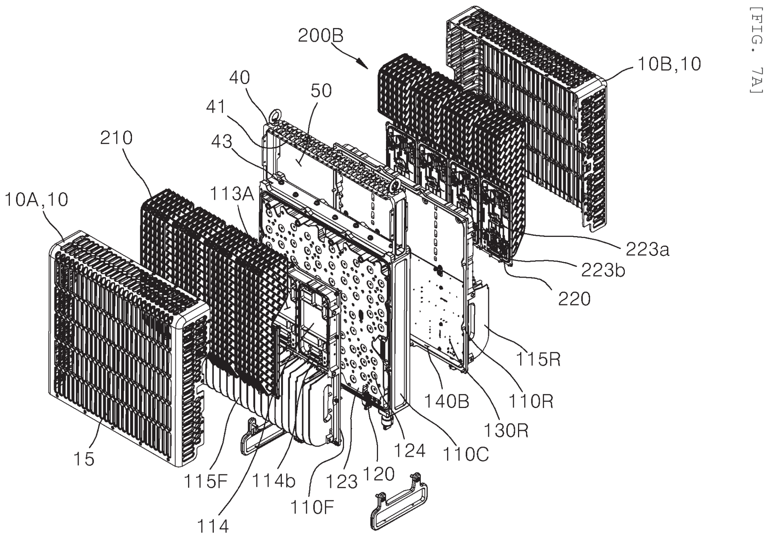

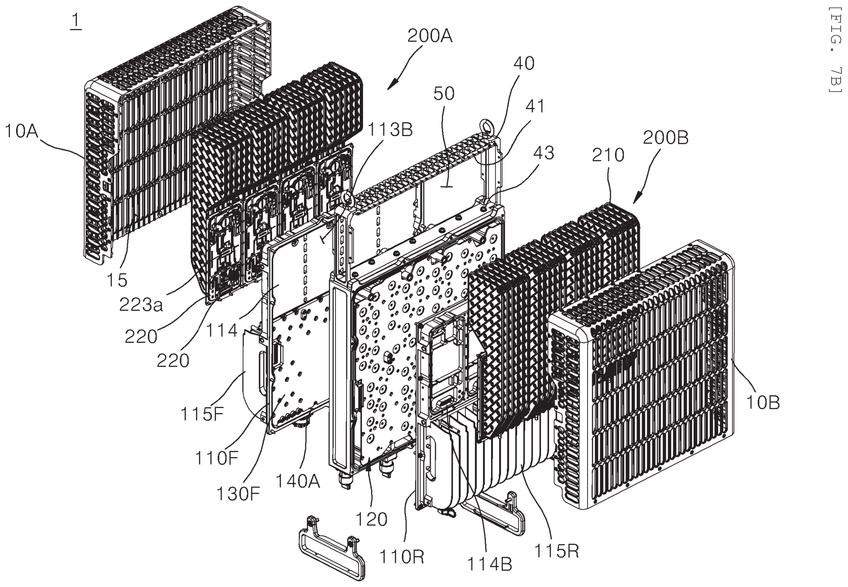

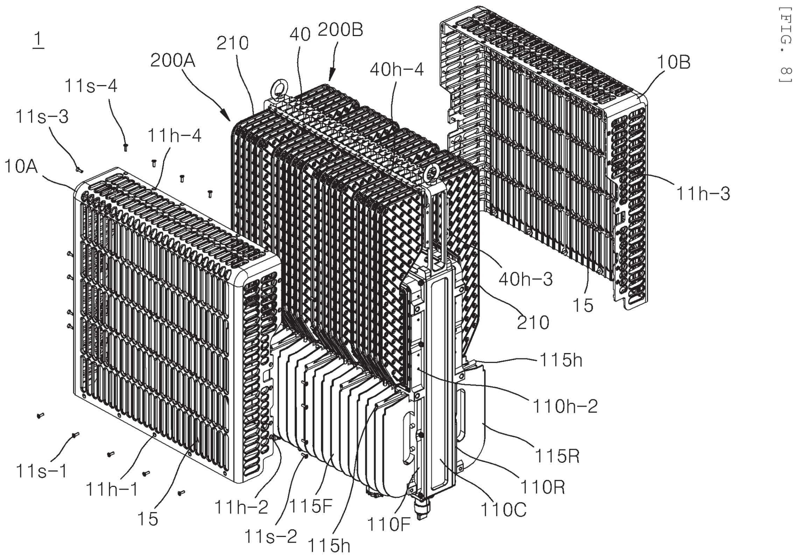

FIGS. 7A and 7B are entire exploded perspective views of FIGS. 1A and 1B, and FIG. 8 is an exploded perspective view of the finger guard panel assembly of the components in FIG. 1A.

As illustrated in FIGS. 7A and 7B, the housing body 100 may include a center housing 110C formed with an installation space where the RF filter unit 120 to be described below is installed, a front heat dissipation housing 110F provided on a front portion of the center housing 110C and facilitating the installation of a front heat dissipation module 200A in which the plurality of heat dissipation devices 210 according to an embodiment of the present disclosure are combined in a modular form, and a rear heat dissipation housing 110R provided on a rear portion of the center housing 110C and facilitating the installation of a rear heat dissipation module 200B in which the plurality of heat dissipation devices 210 according to an embodiment of the present disclosure are combined in a modular form.

That is, as illustrated in FIGS. 7A and 7B, it can be seen that the radio unit 1 includes the housing body 100, the front heat dissipation module 200A disposed at the front portion of the housing body 100, and the rear heat dissipation module 200B disposed at the rear portion of the housing body 100 and the front heat dissipation module 200A and the rear heat dissipation module 200B are each formed by combining the plurality of heat dissipation devices 210 according to an embodiment of the present disclosure in a modular form.

As illustrated in FIGS. 7A and 7B, the radio unit 1 may further include the RF filter unit 120.

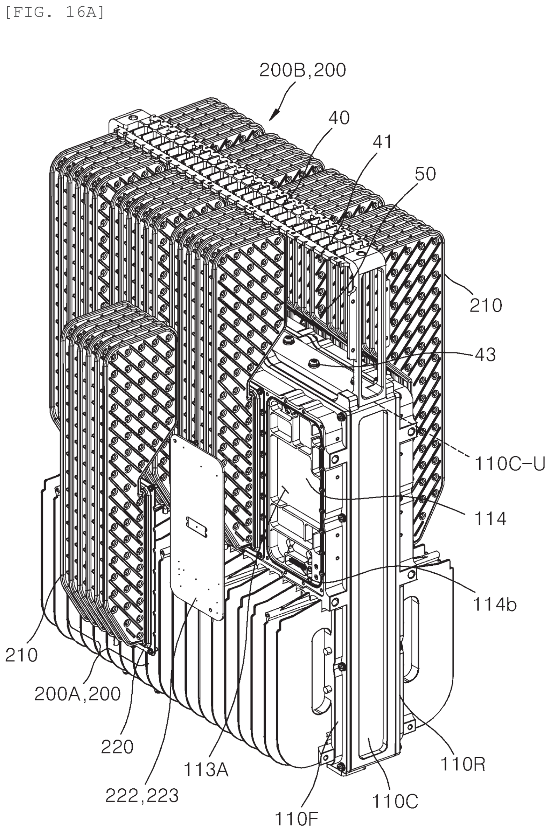

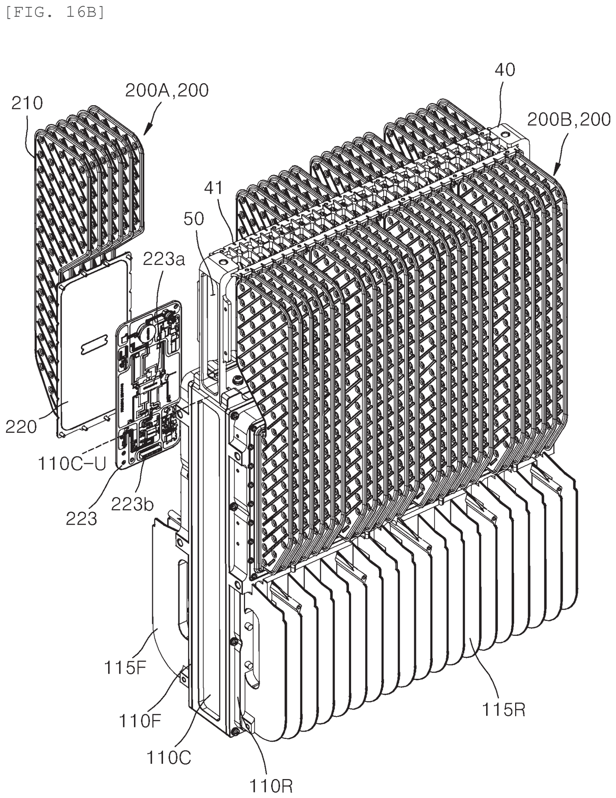

The RF filter unit 120 may include a cavity filter-type filter body (see reference numeral '121' in FIG. 16) provided therein with a plurality of resonators (see reference numeral '122' in FIG. 16). However, the RF filter unit 120 is not necessarily limited to a cavity filter type and may be provided as a waveguide filter type.

As illustrated in FIG. 16 to be described below, the filter body 121 can be shielded by a filter tuning cover 123 in which one side formed with a cavity is formed to be open and a plurality of engraving portions 124 for fine frequency tuning are formed on the open one side.

The housing body 100 is formed in a square frame shape and may include the center housing 110C formed to penetrate in the front-rear direction to allow the RF filter unit 120 to be installed, and the front heat dissipation housing 110F and the rear heat dissipation housing 110R coupled to the front and rear portions of the center housing 110C, respectively.

The front heat dissipation housing 110F and the rear heat dissipation housing 110R are respectively coupled to the front and rear portions of the center housing 110C where the RF filter unit 120 is installed, and a plurality of heat dissipation fins 115F and 115R can be integrally formed on the front portion of the front heat dissipation housing 110F and the rear portion of the rear heat dissipation housing 110R, respectively, for external heat dissipation through heat exchange with outside air.

The front heat dissipation housing 110F and the rear heat dissipation housing 110R are provided in the form of panels having approximately the same size as the center housing 110C, and can be formed to a size sufficient for completely covering the front and rear portions of the center housing 110C that are penetrated in the front-rear direction.

The plurality of heat dissipation fins 115F and 115R can be integrally formed at the lower portion of each of the front surface of the front heat dissipation housing 110F and the rear surface of the rear heat dissipation housing 110R.

The plurality of heat dissipation fins 115F and 115R formed on the front portion of the front heat dissipation housing 110F and the rear portion of the rear heat dissipation housing 110R can be formed to be vertically long so that, when dissipated heat forms an upward airflow, no flow resistance occur due to interference by adjacent heat dissipation fins 115F and 115R.

The plurality of heat dissipation fins 115F and 115R may include front heat dissipation fins 115F protruding forward from the front portion of the panel-shaped front heat dissipation housing 110F and rear heat dissipation fins 115R protruding backward from the rear portion of the panel-shaped rear heat dissipation housing 110R.

The front heat dissipation housing 110F and the rear heat dissipation housing 110R are made of a thermal conductive material (metal material) capable of transferring a certain amount of heat. Since the front heat dissipation fins 115F and the rear heat dissipation fins 115R are also integrally formed, it is natural that they are also made of a thermal conductive material.

However, even when the front heat dissipation fins 115F and the rear heat dissipation fins 115R are made of a metal material with excellent thermal conductivity, the limitations of the thermal conductivity of the material itself make it not possible to extend them infinitely far from the point, where the heating substance is located, in order to increase a surface area for heat dissipation. In this regard, the front end position of a front side or the rear end position and lower end position of a rear side need be optically designed according to the surrounding environment.

The front heat dissipation housing 110F and the rear heat dissipation housing 110R can be formed with a plurality of module coupling grooves 113A and 113B provided to facilitate coupling of the front heat dissipation module 200A and the rear heat dissipation module 200B in which the plurality of heat dissipation devices 210 according to an embodiment of the present disclosure are combined in a modular form, respectively.

As illustrated in FIGS. 7A and 7B, the plurality of module coupling grooves 113A and 113B are provided in the form of square through holes at the upper ends of the front heat dissipation housing 110F and the rear heat dissipation housing 110R, and can be spaced apart from each other in the left-right direction.

The plurality of module coupling grooves 113A and 113B are formed to pass through the front heat dissipation housing 110F and the rear heat dissipation housing 110R in the front-rear direction. However, since a clamshell cover 114 to be described below is coupled to provide shielding in the front-rear direction, the component name "coupling grooves" rather than "coupling holes" is given.

For example, the front heat dissipation housing 110F and the rear heat dissipation housing 110R can be provided with the plurality of module coupling grooves 113A and 113B, respectively, in such a manner that four front heat dissipation modules 200A and four rear heat dissipation modules 200B, each of which is provided with a combination of the plurality of heat dissipation devices 210 to be described below according to an embodiment of the present disclosure, are installed in the front-rear direction, respectively.

In addition, when the front heat dissipation module 200A and the rear heat dissipation module 200B, each of which is provided with a combination of the plurality of heat dissipation devices 210 according to an embodiment of the present disclosure, are completely installed in the front heat dissipation housing 110F and the rear heat dissipation housing 110R, respectively, the finger guard panel assembly 10 can be installed to cover the entire heat dissipation device 210 and heat dissipation modules 200A and 200B to prevent burns to workers or outsiders due to high-temperature heat emitted from the heat dissipation devices 210.

The finger guard panel assembly 10 can be formed with a plurality of air flow holes 15 formed in a grille shape to facilitate the inflow and outflow of air to and from a heat exchange region 50 to be described below.

As illustrated in FIGS. 7A and 7B, and FIG. 8, the finger guard panel assembly 10 can be disposed to cover the entirety or the upper portion of the heat dissipation device 210 and the heat dissipation module 200 to be described below according to an embodiment of the present disclosure, which are installed in each of the center housing 110C to be described below among the configurations of the radio unit 1, the front heat dissipation housing 110F, and the rear heat dissipation housing 110R.

More specifically, the finger guard panel assembly 10 may include a front finger guard panel 10A coupled to the front portion of the front heat dissipation housing 110F, and a rear finger guard panel 10B coupled to the rear portion of the rear heat dissipation housing 110R.

The front finger guard panel 10A has a rectangular parallelepiped shape with open rear and lower portions, and the rear finger guard panel 10B has a rectangular parallelepiped shape with open front and lower portions. The front finger guard panel 10A and the rear finger guard panel 10B can each be formed with the plurality of air flow holes 15 so that heat exchange is possible between outside air and the heat dissipation device 210 according to an embodiment of the present disclosure.

A lower end of the front finger guard panel 10A can be screw-fixed to the plurality of heat dissipation fins 115F integrally formed at the lower end of the front heat dissipation housing 110F by lower fixing screws 11s-1 to be described below, and the left and right portions thereof can be screw-fixed to screw fastening holes 110h-2 provided at the left and right side portions of the center housing 110C and screw fastening holes 40h-3 provided at the left and right side portions of a guide panel 40 to be described below by first side fixing screws 11s-2 and second side fixing screws 11s-3, respectively. To this end, screw fastening holes 115h for fastening the lower fixing screws 11s-1 can be integrally formed at the upper end of at least one of the plurality of heat dissipation fins 115F, and a plurality of lower screw through holes 11h-1 through which the lower fixing screws 11s-1 pass can also be formed at the lower end of the front finger guard panel 10A.

In addition, a plurality of screw through holes 11h-4 can be vertically formed through the upper rear end of the front finger guard panel 10A, and screw fastening holes 40h-4, into which a plurality of upper fixing screws 11s-4 are fastened by passing through the plurality of screw through holes 11h-4, can be formed at the upper end of the guide panel 40 to be described below and screw-fixed by the plurality of upper fixing screws 11s-4.

Since the undescribed coupling structure of the rear finger guard panel 10B to the rear heat dissipation housing 110R and the guide panel 40 is completely identical to that of the front finger guard panel 10A described above, the above description is applied.

As illustrated in FIGS. 7A and 7B, a front board 130F, such as a power supply unit (PSU) board, mounted with heating substances (heating substances) that generate a predetermined amount of operating heat can be disposed between the front portion of the RF filter unit 120 and the front heat dissipation housing 110F, and heat generated by the heating substances (such as PSU elements) mounted on the front board 130F can be dissipated through the front heat dissipation fins 115F described above.

As illustrated in FIGS. 7A and 7B, a rear board 130R, such as a printed board assembly (PBA), can be disposed between the rear portion of the RF filter unit 120 and the rear heat dissipation housing 110R, and heat generated by heating substances (such as FPGA elements) mounted on the rear board 130R can be dissipated through the rear heat dissipation fins 115R described above.

As illustrated in FIG. 7B, a front board installation groove 140A can be formed on the rear portion of the front heat dissipation housing 110F for stacking and installing the front board 130F (PSU board). A plurality of PSU elements can be mounted on the front portion of the PSU board being the front board 130F, the heating surfaces of the PSU elements are installed in close contact with an inner surface (front surface) of the front board installation groove 140A, and heat exchange with outside air via the front heat dissipation fins 115F is performed through surface thermal contact with the front heat dissipation housing 110F, thereby achieving front heat dissipation.

As illustrated in FIG. 7A, a rear board installation groove 140B can be formed on the front portion of the rear heat dissipation housing 110R for stacking and installing the rear board 130R (or PBA). A plurality of FPGA elements can be mounted on the front portion of the PBA being the rear board 130R, the heating surfaces of the FPGA elements are installed in close contact with an inner surface (rear surface) of the rear board installation groove 140B, and heat exchange with outside air via the rear heat dissipation fin 115R is performed through surface thermal contact with the rear heat dissipation housing 110R, thereby achieving rear heat dissipation.

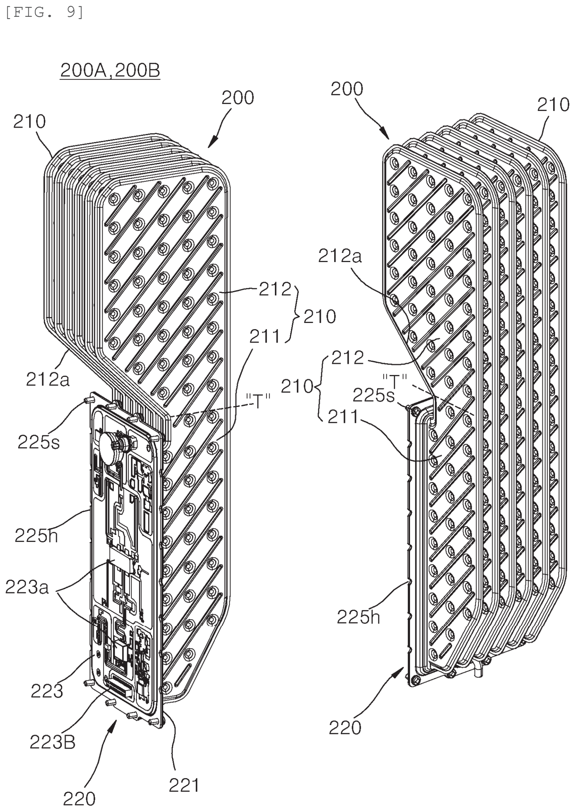

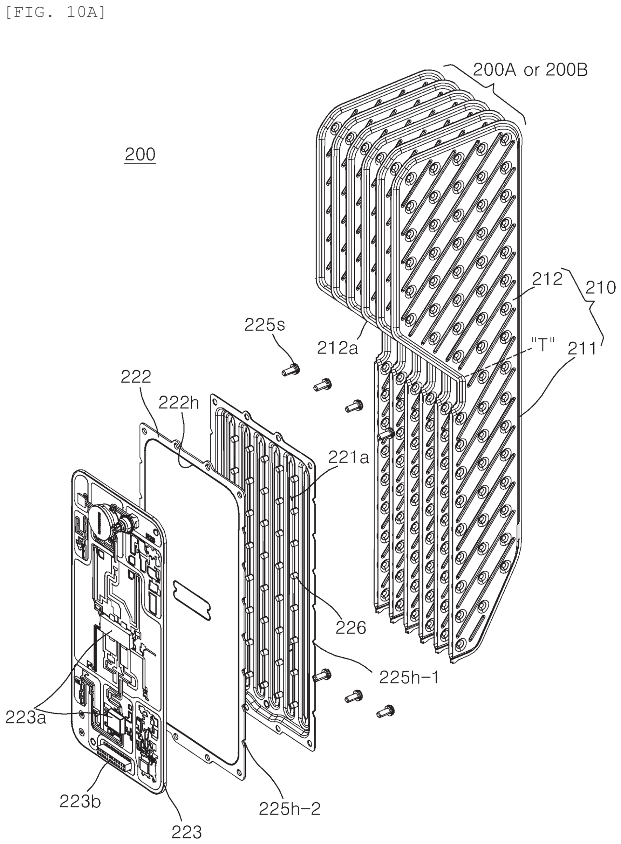

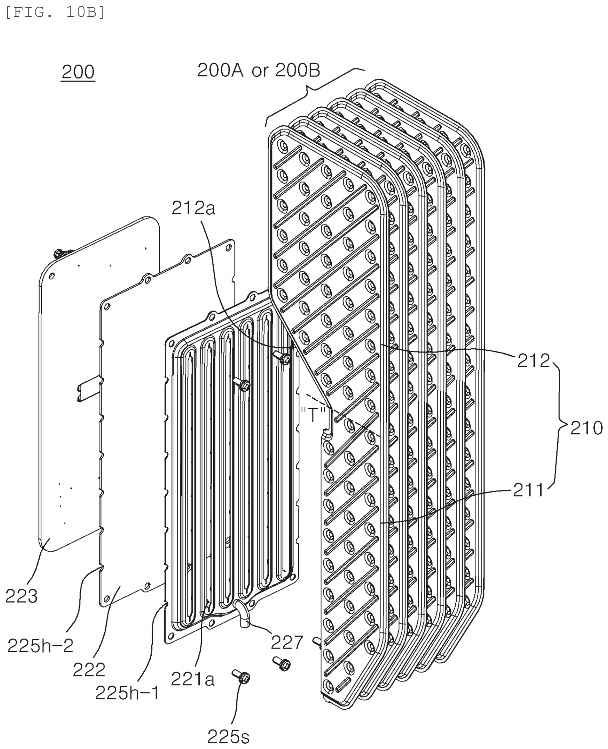

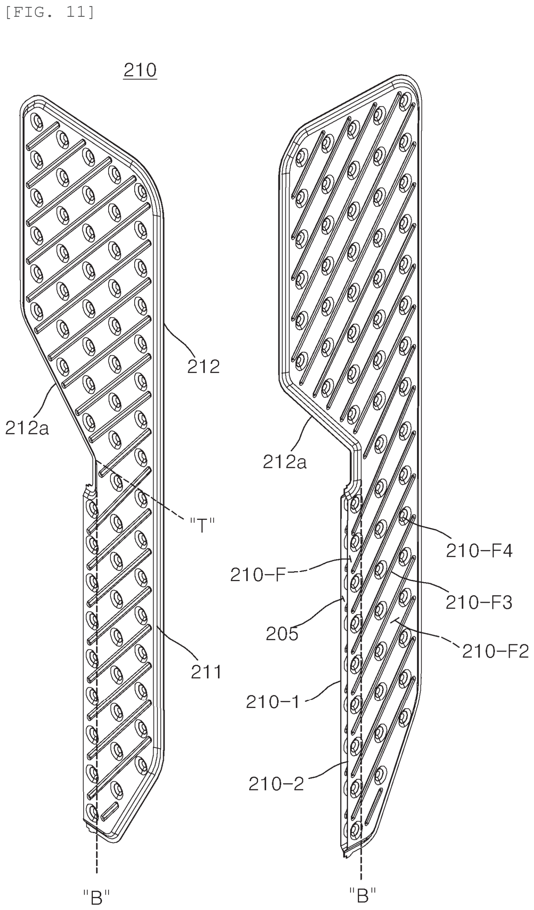

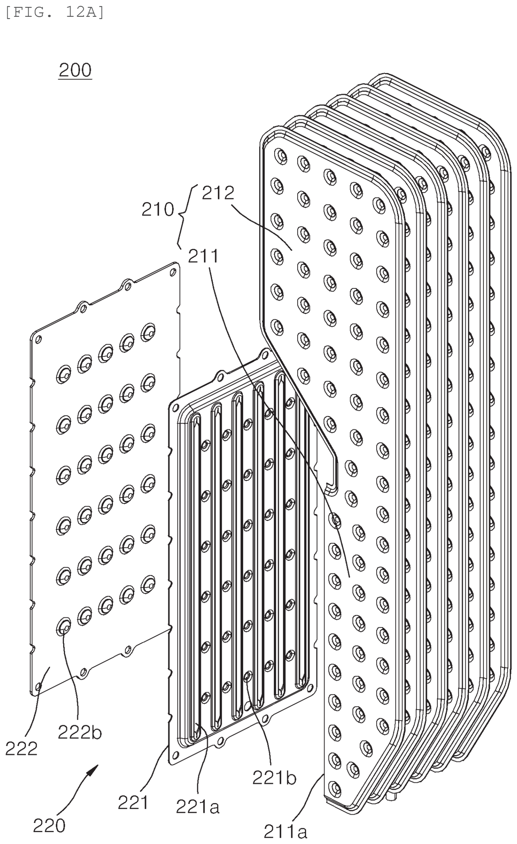

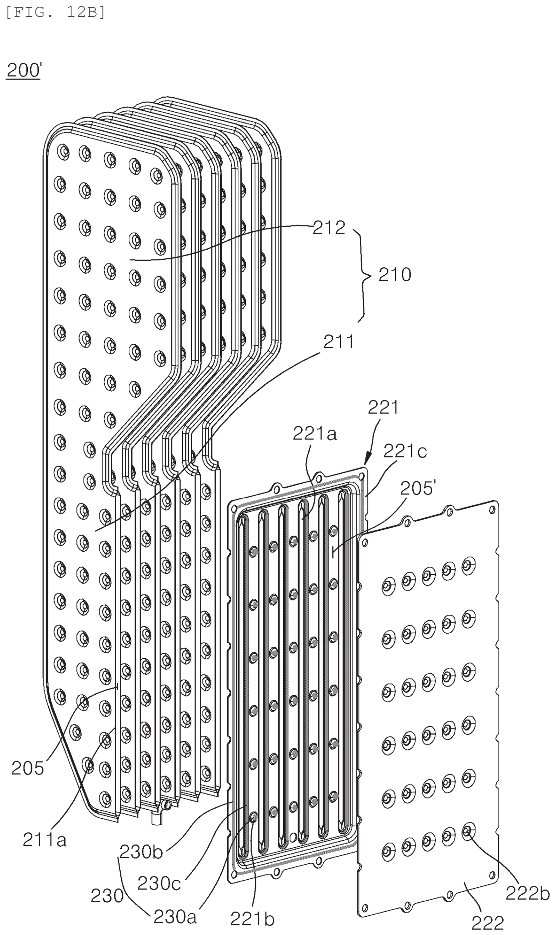

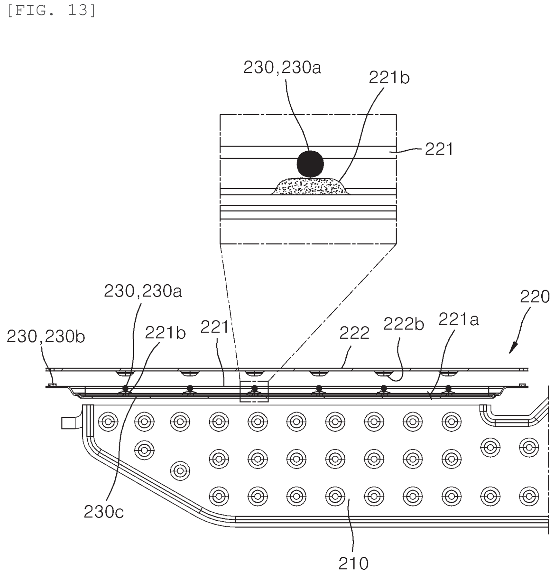

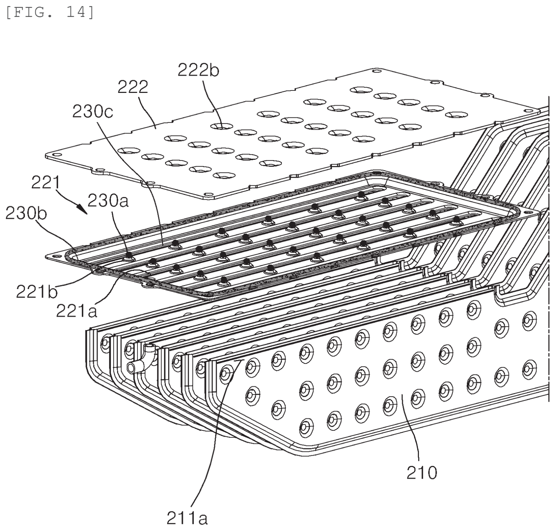

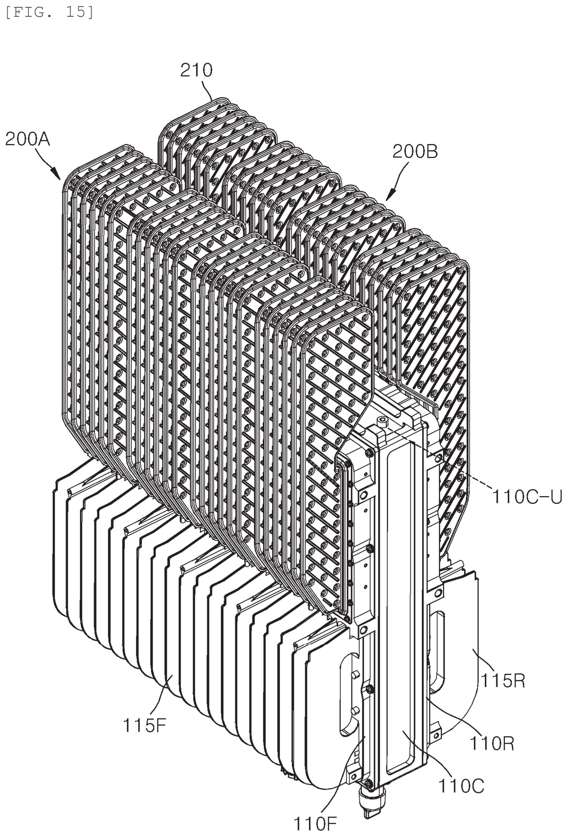

FIG. 9 is front and rear perspective views showing the arrangement state of the heat dissipation device according to an embodiment of the present disclosure, FIGS. 10A and 10B are front and rear exploded perspective views of FIG. 9, FIG. 11 is a perspective view showing the heat dissipation device according to an embodiment of the present disclosure, FIGS. 12A and 12B are front and rear exploded perspective views for explaining a coupling process of a heat dissipation device according to another embodiment of the present disclosure, FIG. 13 is an exploded cross-sectional view for explaining a coupling state with a heat collection part by a brazing welding method, FIG. 14 is an exploded perspective view for explaining a coupling state with a heat collection part by a brazing welding method, FIG. 15 is a perspective view showing a state in which the finger guard panel assembly of components in FIG. 8 is removed, and FIGS. 16A and 16B are front and rear exploded perspective views showing an exploded state of only a front heat dissipation module installed at a front portion of a housing body of components in FIG. 15 and combined with the heat dissipation device according to an embodiment of the present disclosure.

As illustrated in FIGS. 7A and 7B, two or more heat dissipation devices 210 according to an embodiment of the present disclosure can be combined to form a plurality of front heat dissipation modules 200A installed on the front portion of the front heat dissipation housing 110F and a plurality of rear heat dissipation modules 200B installed on the front portion of the rear heat dissipation housing 110R.

Since the front heat dissipation module 200A and the rear heat dissipation module 200B are different from each other only in the installation location, that is, whether the front heat dissipation module 200A and the rear heat dissipation module 200B are installed in the front heat dissipation housing 110F or the rear heat dissipation housing 110R and detailed configuration and coupling relationship thereof are identical to each other, the front heat dissipation module 200A is mainly described below and the description of the front heat dissipation module 200A is applied to the rear heat dissipation module 200B.

As illustrated in FIGS. 7A and 7B, the antenna apparatus (radio unit) 1 according to an embodiment of the present disclosure may further include the guide panel 40 that supports the upper end of the heat dissipation device 210 of each of the front heat dissipation module 200A and the rear heat dissipation module 200B.

The guide panel 40 is formed in an approximately rectangular frame shape and formed to penetrate in the front-rear direction to form the heat exchange region 50 to be described below, and can be screw-assembled to the upper end of the center housing 110C by using a plurality of panel assembly screws 43.

In addition, the screw fastening holes 40h-3 can be formed in the left and right side portions of the guide panel 40 to provide fastening points for the second side fixing screws 11s-3 that are screw-assembled through the side portions of the front finger guard panel 10A and the rear finger guard panel 10B.

An upper end of the guide panel 40 is provided in a grille shape so that at least outside air is smoothly ventilated to the heat exchange region 50, and front and rear ends of the upper end of the guide panel 40 can be formed with guide slits 41, into which the upper ends of the heat dissipation devices 210 are inserted, when the front heat dissipation module 200A and the rear heat dissipation module 200B are coupled to the housing body 100.

The guide slits 41 of the guide panel 40 serve to prevent damage to the heat dissipation device 210 by limiting the left-right shaking (clearance) of the upper ends of the plurality of heat dissipation devices 210 extending beyond the upper end of at least the center housing 110C of the housing body 100.

The guide panel 40 can also provide a screw assembly portion for stably coupling the finger guard panel assembly 10.

As illustrated in FIG. 9, the front heat dissipation module 200A may include a heat transfer member 221 for coupling and two or more heat dissipation devices 210 coupled to the heat transfer member 221 for coupling.

The front heat dissipation modules 200A configured as described above can be coupled to the front heat dissipation housing 110F via the heat transfer member 221 for coupling by inserting the heat transfer member 221 for coupling into each of the plurality of module coupling grooves 113A and 113B formed in the front heat dissipation housing 110F (or the rear heat dissipation housing 110R).

In such a case, the heat transfer member 221 for coupling can be provided with a groove-shaped board receiving part 222h embedding a PA board that has heating substances (such as PA elements 223a with a relatively high heat generation amount among RF components) and is mounted separately from the front board 130F and the rear board 130R, the heating substances having different properties from the heat heating substances mounted on the front board 130F and the heat heating substances mounted on the rear board 130R.

In particular, the heat transfer member 221 for coupling can be provided in the form of a vapor chamber in which refrigerant is filled therein and transfers heat while flowing by changing phases due to heat transferred from the heating substances.

In general, a vapor chamber is in a state in which liquid refrigerant is filled and a heat transfer means that serves to transfer heat from one side to the other side by repeating a process in which the liquid refrigerant is evaporated into gaseous refrigerant through a wick structure, in which refrigerant is formed to include a plurality of pores therein, due to heat transferred from the outside, flows and is condensed in a low-temperature region to be phase-changed back into liquid refrigerant.

However, the heat transfer member 221 for coupling does not necessarily have to be provided in the form of a vapor chamber. That is, the heat transfer member 221 for coupling can be simply provided in the form of a panel made of a metal material (heat conductive material) as long as it can transfer heat generated from a heating substance to the heat dissipation device 210 according to an embodiment of the present disclosure.

A plurality of screw fastening grooves 225h-1 and 225h-2 are formed in a semicircular cut shape at the left and right ends of a rim end of each of the heat transfer member 221 for coupling and a shielding cover 222 to be described below, and a plurality of module assembly screws 225s having flat heads are screw-coupled to screw fastening holes (not illustrated) formed corresponding to the rim ends of the module coupling grooves 113A and 113B of the front heat dissipation housing 110F and the rear heat dissipation housing 110R while being caught in the plurality of screw fastening grooves 225h-1 and 225h-2, so that the front heat dissipation module 200A and the rear heat dissipation module 200B can be stably fixed to the front heat dissipation housing 110F and the rear heat dissipation housing 110R, respectively.

One surface of the heat transfer member 221 for coupling can be formed to face the heating substance (that is, the PA element 223a) of the PA board 223, and the other surface of the heat transfer member 221 for coupling can be formed with a plurality of fixed slits 221a for installing the heat dissipation device 210 according to an embodiment of the present disclosure. That is, the heat dissipation device 210 according to an embodiment of the present disclosure can receive heat from the heating substance via the heat transfer member 221 for coupling.

Two or more (six in this embodiment) heat dissipation devices 210 according to an embodiment of the present disclosure can be coupled to the other surface of the heat transfer member 221 for coupling so as to be orthogonal to the other surface of the heat transfer member 221 for coupling.

The one surface of the heat transfer member 221 for coupling can be disposed to be in surface thermal contact with the heating substance (PA element 223a) of the PA board 223, which is disposed separately from the front board 130F and the rear board 130R, as the front or rear portion of the RF filter unit 120. Preferably, as illustrated in FIGS. 9 and 10A, the one surface of the heat transfer member 221 for coupling can be in surface thermal contact with the heating substance (PA element 223a) of the PA board accommodated in the board receiving part 222h.

More specifically, a plurality of heating substances are mounted on the front surface of the front board 130F and the rear surface of the rear board 130R. In the case of the radio unit 1, the front board 130F may be a PSU board, and the rear board 130R may be a PBA type main board. Typically, various types of heating substances, such as digital driving elements such as the aforementioned FPGA element and analog driving elements such as the aforementioned PA element 223a, may be mainly mounted on the main board.

Among such heating substances, the PA element 223a belongs to a heating substance with a relatively large heat generation amount because it operates while consuming relatively large power. In order to mount only the PA elements 223a, each PA board 223 is manufactured separately from the main board being the rear board 130R and inserted into the board receiving part 222h provided in the heat transfer member 221 for coupling of a plurality of front heat dissipation modules 200A and rear heat dissipation modules 200B, and is accommodated in the board receiving part 222h on one surface of the heat transfer member 221 for coupling, so that heat generated from the PA elements 223a can be directly transferred and dissipated to the heat dissipation device 210 according to an embodiment of the present disclosure through the heat transfer member 221 for coupling.

The heat transfer member 221 for coupling and the board receiving part 222h can be partitioned by the shielding cover 222, and the shielding cover 222 can serve to transfer heat generated by the heating substance to the heat transfer member 221 for coupling.

Since the plurality of fixed slits 221a are cut to be horizontally spaced apart from each other on the other surface of the heat transfer member 221 for coupling so that the plurality of heat dissipation devices 210 according to an embodiment of the present disclosure are coupled, the rigidity of the other surface of the heat transfer member 221 for coupling may be reduced.

In order to prevent the reduction in the rigidity of the heat transfer member 221 for coupling, a plurality of support pins 226 can be further provided, each having one end supported by the shielding cover 222 and the other end supported between adjacent fixed slits 221a.

The plurality of support pins 226 reinforce the rigidity of the heat transfer member 221 for coupling by preventing the heat transfer member 221 for coupling from being pressed by external forces transmitted from the one surface and the other surface thereof, and serve to prevent leakage of the refrigerant filled therein.

The interior of the heat transfer member 221 for coupling configured as described above can be formed to communicate with refrigerant flow spaces 205 formed inside the plurality of heat dissipation devices 210 via the plurality of fixed slits 221a so that the refrigerant is shared.

The PA board 223 is shielded by the clamshell cover 114 that covers the board receiving part 222h of the heat transfer member 221 for coupling, thereby preventing the intrusion and interference of external radio waves.

Although not illustrated in the drawing, the clamshell cover 114 can also be coupled to the heat transfer member 221 for coupling so as to cover the entire PA board accommodated in the board receiving part 222h of the heat transfer member 221 for coupling. As illustrated in FIGS. 7A and 7B, the clamshell cover 114 can also be provided in a state of being coupled to the module coupling grooves 113A and 113B of the front heat dissipation housing 110F and the rear heat dissipation housing 110R.

In this way, the heat dissipation device 210 according to an embodiment of the present disclosure is manufactured as a modularized front heat dissipation module 200A or rear heat dissipation module 200B in which a plurality of heat dissipation devices 210 are coupled together with the PA board 223 coupled to the one surface of the heat transfer member 221 for coupling. This allows for easy product installation and application after active design changes according to variable design environments such as the heat generation amount of a heating substance.

The heat transfer member 221 for coupling, the PA board 223, and the clamshell cover 114 (limited to a case where the clamshell cover 114 is not provided in a state of being coupled to the module coupling grooves 113A and 113B of the front heat dissipation housing 110F and the rear heat dissipation housing 110R) can be manufactured in a modular form, and can be defined as a heat collection part 220 corresponding to the heat dissipation device 210 according to an embodiment of the present disclosure.

As illustrated in FIG. 9, FIGS. 10A and 10B, and FIG. 11, the heat dissipation device 210 according to an embodiment of the present disclosure may include a heat receiving part 211 that collects heat generated from heating substances (particularly, the PA elements 223a), and a heat discharging part 212 that performs heat exchange with outside air by diffusing the heat collected by the heat receiving part 211 and is formed to occupy at least a part of the heat exchange region (see reference numeral '50' in FIG. 15 to be described below) corresponding to the direct upper part of the housing body 100 in such a manner that at least a tip of the heat discharging part 212 extends to the heat exchange region 50 on the upper outer side of the housing body 100 provided with the heating substances.

That is, in the heat dissipation device 210 according to an embodiment of the present disclosure, even when the heat receiving part 211 is disposed to overlap the front portion of the front heat dissipation housing 110F or the rear portion (back portion) of the rear heat dissipation housing 110R of the housing body 100 in the front-rear direction, the heat discharging part 212 is formed to extend upward beyond the upper end of the housing body 100. In such a case, the heat discharging part 212 can be disposed so that at least a part thereof occupies at least a part of the heat exchange region 50 corresponding to the direct upper part of the housing body 100 in the front-rear thickness direction.

In accordance with the heat dissipation device 210 according to an embodiment of the present disclosure, even in the case of increasing the heat dissipation area of the heat discharging part 212 that actually performs a heat dissipation function, the heat dissipation area can be increased to the heat exchange region 50 corresponding to the direct upper portion of the housing body 100 in the front-rear thickness direction without extending in the front-rear thickness direction of the housing body 100, thereby providing the advantage of avoiding design for increasing the size of a product.

The heat receiving part 211 and the heat discharging part 212 are described separately in terms of functions thereof, but are not construed to be limited to having a physically complete partition line (point).

For example, the heat receiving part 211 and the heat discharging part 212 can be integrally formed. In such a case, the heat receiving part 211 and the heat discharging part 212 do not have a physically distinct boundary. However, as described above, the heat discharging part 212 is preferably construed as referring to a part that protrudes and extends toward the heat exchange region 50 corresponding to the upper end of the housing body 100.

The heat receiving part 211 is preferably formed to have a thickness and length suitable for insertion into the fixed slit 221a formed on the other surface of the heat transfer member 221 for coupling. That is, it can be understood that the thickness and length of the heat receiving part 211 are formed to easily fix the heat receiving part 211 to the fixed slit 221a through a force-fit or press-fit method. However, the method of coupling the heat receiving part 211 to the fixed slit 221a is not necessarily limited to a force-fit method or a press-fit method, and as in a heat dissipation module 200' according to another embodiment of the present disclosure to be described above, the heat receiving part 211 can also be coupled to the fixed slit 221a by a welding coupling method or a brazing coupling method. This is described in more detail below.

In particular, as illustrated in FIG. 11, the heat receiving part 211 can be formed with a fitting end 211a protruding toward the fixed slit 221a by a predetermined length based on a virtual straight line B identical to an end of a neck portion 211b at a lower portion of a virtual boundary point T corresponding to a starting point, from which the heat discharging part 212 extends, so that a part of the heat receiving part 211 is inserted into the fixed slit 221a.

As illustrated in FIG. 11, the heat dissipation device 210 according to an embodiment of the present disclosure is provided to form the refrigerant flow space 205 filled with refrigerant therein.

In such a case, the heat dissipation device 210 can be manufactured by preparing a single metal panel member having a predetermined thermal conductivity in advance through a press process using a sheet metal mold and then forming the sealed refrigerant flow space 205 by bending at least one side of the metal panel member and joining rim ends thereof, or by separately manufacturing two metal panel members having a predetermined thermal conductivity through a press process and then joining the two metal panel members along rim ends so that the sealed refrigerant flow space 205 is formed therein.

A portion forming one side of the refrigerant flow space 205 is referred to as a one-side thermal conductive panel 210-1, and a portion forming the other side of the refrigerant flow space 205 is referred to as the other-side thermal conductive panel 210-2.

When the heat dissipation device 210 according to an embodiment of the present disclosure is vertically disposed with respect to the direction of gravity, liquid refrigerant is stored toward the heat receiving part 211 formed with the fitting end 211a inserted into and fixed to the fixed slit 221a relatively corresponding to the heat collection part 220. Remaining evaporated gaseous refrigerant is diffused to the heat discharging part 212, which is located above the boundary point T, and is condensed into liquid refrigerant through heat exchange with outside air in the heat exchange region 50.

Referring to FIG. 11, it is not possible to physically completely divide the refrigerant flow space 205, but as a functional classification according to the phase change of the refrigerant, a portion of the heat receiving part 211 where the fitting end 211a close to the heating substances is formed can be defined as a first refrigerant passage 210-F1, and a portion of the heat receiving part 211 partitioned by an inclined guide 210-F3 to be described below and inducing the inclined flow of the liquid refrigerant can be defined as a second refrigerant passage 210-F2.

When the gaseous refrigerant diffused through the heat receiving part 211 and the heat discharging part 212 is condensed through heat exchange with outside air in the heat exchange region 50 and is phase-changed into liquid refrigerant, the liquid refrigerant is distributed in a uniform amount through the second refrigerant passage 210-F2 formed in a plurality of inclined guides 210-F3 formed to be inclined downward toward the first refrigerant passage 210-F1 and is flown toward the first refrigerant passage 210-F1, thereby promoting smoother gas-liquid circulation.

The heat dissipation device 210 according to an embodiment of the present disclosure is generally manufactured using a very thin SUS metal panel member through the aforementioned pressing process. However, since shaking (fluctuation) may be induced by a change in internal pressure due to phase changes within the refrigerant flow space 205, a plurality of joining portions 210-F4 can be simultaneously formed during the pressing process to prevent such shaking.

The plurality of joining portions 210-F4 are formed to protrude by a predetermined depth from the one-side thermal conductive panel 210-1 and the other-side thermal conductive panel 210-2 toward the refrigerant flow space 205. The plurality of joining portions 210-F4 are joined together by a joining method including a welding method during the joining process for sealing the refrigerant flow space 205, thereby reinforcing the rigidity of the one-side thermal conductive panel 210-1 and the other-side thermal conductive panel 210-2.

In this way, the heat dissipation device 210 according to an embodiment of the present disclosure provides the advantage of being designed to effectively perform heat exchange in the heat exchange region 50 even through the heat discharging part 212 extending above the upper end of the center housing 110C of the housing body 100, by using refrigerant capable of actively changing phases due to heat transferred from a heating substance, instead of heat exchange depending on the thermal conductivity of a metal material itself.

The heat receiving part 211 and the heat discharging part 212 do not necessarily have to be integrally formed as described above. Although not illustrated in the drawing, the heat receiving part 211 may be a heat pipe filled with refrigerant that flows while changing phases, and the heat discharging part 212 may be a heat sink fin in thermal contact with and coupled to a tip of the heat pipe.

The heat pipe, like the vapor chamber described above, has an internal wick structure, has a pipe-shaped external appearance, and refers to a component capable of performing a function as a heat transfer medium that transfers (transports) heat supplied to one end to the other end over a long distance.

Preferably, the heat sink fin is construed as generally referring to a component that transfers heat using the thermal conductivity of a material itself, without the help of a phase-change material such as refrigerant.

In the heat dissipation device 210 according to an embodiment of the present disclosure, the heat receiving part 211 can adopt a heat pipe filled with refrigerant that flows while changing phases, and the heat discharging part 212 can adopt a vapor chamber filled with refrigerant that flows while changing phases.

However, the heat dissipation device 210 according to an embodiment of the present disclosure is not necessarily limited to be adopted only to a structure of increasing a heat transfer rate through phase changes of refrigerant, and the heat receiving part 211 and the heat discharging part 212 can adopt general heat sink fins integrally formed using a predetermined metal material.

Assuming that the heat dissipation device 210 according to an embodiment of the present disclosure uses refrigerant as a heat transport and heat exchange medium, the heat receiving part 211 may include an evaporation region where the refrigerant is phase-changed into refrigerant in a gaseous state, and the heat discharging part 212 may include a condensation region where the refrigerant is phase-changed into refrigerant in a liquid state through heat exchange with outside air in the heat exchange region 50.

On the other hand, as illustrated in FIGS. 12A and 12B, the heat dissipation module 200' according to another embodiment of the present disclosure can be coupled to the rear portion of the housing body 100 via the heat collection part 220.

As described above, the heat collection part 220 may include the heat transfer member 221 for coupling and the shielding cover 222. The heat collection part 220 can be provided in the form of a vapor chamber in which a refrigerant-filled space filled with predetermined refrigerant is provided inside the heat transfer member 221 for coupling.

Hereinafter, a space as an interior of the heat dissipation devices 210 according to an embodiment of the present disclosure, where refrigerant is filled and flows, is referred to as the 'refrigerant flow space 205', and a space provided in the heat collection part 220, where refrigerant is filled, is referred to as a 'refrigerant-filled space 205'.

The other surface of the heat transfer member 221 for coupling can be formed with the plurality of fixed slits 221a for insertion of a part (for example, the fitting end 211a) of the heat receiving part 211 among the components of the heat dissipation device 210 so that a plurality of heat dissipation devices 210 are combined in a modular form to form the heat dissipation module 200.

The fitting ends 211a of the heat receiving parts 211 preferably protrude and are inserted through the plurality of fixed slits 221a to be exposed to the refrigerant-filled space 205' so that the fitting ends 211a are directly exposed to vaporized gaseous refrigerant in the refrigerant-filled space 205'.

However, since the refrigerant-filled space 205' is a space where refrigerant is filled and flows, there is a problem in that a gap between the fixed slit 221a and the fitting end 211a of the heat receiving part 211 needs to be completely sealed in order to prevent the refrigerant from leaking to the outside. In order to seal the gap, a method for interposing a separate sealing member (such as rubber) may be considered. However, a contraction-expansion process due to repeated thermal changes may cause thermal deformation, making complete sealing difficult, and a strong material needs to be selected in consideration of thermal deformation, corrosion resistance, strength, oxidation resistance, and the like. Simultaneously, this increases the number of components and thus process steps, increases the weight of a product, and causes rise in costs.

In order to solve the above-described problems, the heat dissipation device 210 according to an embodiment of the present disclosure proposes a technical feature that the heat transfer member 221 for coupling and the shielding cover 222 seal the refrigerant-filled space during joining in a state in which the fitting end 211a of at least one heat receiving part 211 is inserted into the plurality of fixed slits 221a.

The joining can be performed using any one of a brazing welding method and a laser welding method. The following description is given on the assumption that the brazing welding method of the methods is applied.

More specifically, as illustrated in FIGS. 12A, 12B, 13, and 14, the heat transfer member 221 for coupling can further be provided with a plurality of rigid reinforcing dot portions 221b protruding toward the shielding cover 222 along a gap between the fixed slits 221a.

For example, the plurality of fixed slits 221a can be formed to be vertically long in the heat transfer member 221 for coupling to communicate with the refrigerant-filled space 205', and can be horizontally formed to be spaced apart from each other by a predetermined distance so that the plurality of heat dissipation devices 210 are coupled to each other. The plurality of rigid reinforcing dot portions 221b can be vertically provided between the fixed slits 221a to be spaced apart from each other by a predetermined distance.

The plurality of rigid reinforcing dot portions 221b are configured to enhance the inherent rigidity of the heat transfer member 221 for coupling whose rigidity has been weakened by being partially cut by the plurality of fixed slits 221a.

However, the function of the plurality of rigid reinforcing dot portions 221b is not limited only to enhancing rigidity, and the plurality of rigid reinforcing dot portions 221b may have an additional function as a coupling portion that contacts and is welded to a plurality of welding dot portions 222b, which are to be described below, formed in the shielding cover 222.

That is, the plurality of rigid reinforcing dot portions 221b can also increase the coupling rigidity with the shielding cover 222 through welding coupling with the welding dot portions 222b, which are to be described below, formed in the shielding cover 222 in order to prevent thermal deformation that may occur during a contraction-expansion process due to repeated thermal changes.

The shielding cover 222 can be provided with the plurality of welding dot portions 222b that protrude toward the heat transfer member 221 for coupling at locations corresponding to the plurality of rigid reinforcing dot portions 221b.

When the plurality of rigid reinforcing dot portions 221b and the plurality of welding dot portions 222b are provided, the plurality of support pins 226 may not be provided. That is, the plurality of rigid reinforcing dot portions 221b and the plurality of welding dot portions 222b may be understood as alternative configurations for the plurality of support pins 226.

When the shielding cover 222 is joined to the heat transfer member 221 for coupling by a brazing welding method, a filler metal 230 can be applied along the plurality of rigid reinforcing dot portions 221b and a rim end 221c of the heat transfer member 221 for coupling.

The filler metal 230 may contain nickel. More specifically, the filler metal 230 contains nickel as a main component, and can be provided in a paste type or an alloy type for easy application to the plurality of rigid reinforcing dot portions 221b, the rim end 221c of the heat transfer member 221 for coupling, and the fixed slits 221a. The filler metal 230 can also be used in a silver (Ag) paste type, but has poor corrosion resistance, may cause oxidation, and increases costs compared to a case where nickel is a main component.

Hereinafter, as illustrated in FIGS. 13 and 14, the filler material 230 applied to each of the plurality of rigid reinforcing dot portions 221b is referred to as an inner filler material 230a, the filler material 230 applied along the rim end 221c of the heat transfer member 221 for coupling is referred to as a rim filler material 230b, and the filler material 230 applied along the inner end of the fixed slit 221a is referred to as a fixed-slit filler material 230c.

As illustrated in FIGS. 13 and 14, the rim filler material 230b is applied along the rim end 221c of the heat transfer member 221 for coupling in advance before the shielding cover 222 is joined to the heat transfer member 221 for coupling by a brazing welding method, and when the joining is performed by the brazing welding method, the rim filler material 230b melts at a high temperature to be in close contact with the shielding cover 222, and is cured along the rim end 221c between the heat transfer member 221 for coupling and the shielding cover 222 for sealing.

The inner filler material 230a is applied to each of the rigid reinforcing dot portions 221b to allow the shielding cover 222 to be closely placed in position from top and bottom, and then melts at a high temperature when the joining is performed by the brazing welding method, so that the plurality of rigid reinforcing dot portions 221b and the plurality of welding dot portions 222b of the shielding cover 222 can be joined together during the curing process.

In addition, the fixed-slit filler material 230c naturally flows in the direction of gravity when the joining is performed by the brazing welding method, that is, flows inside the fixed slit 221a, and fills a gap between the fixed slits 221a and the fitting end 211a of the heat receiving part 211 and then cured, thereby sealing the refrigerant-filled space 205'.

To this end, the fixed-slit filler material 230c can be applied in advance to the inner end of the fixed slit 221a of the heat transfer member 221 for coupling in a state in which the fitting end 211a of the heat receiving part 211 is inserted into the fixed slit 221a.

In this way, the heat dissipation module 200' according to another embodiment of the present disclosure uses joining by a brazing welding method in order to perform a coupling process with the heat collection part 220 provided in the form of a vapor chamber, and allows, in the joining process, the filler metal (in particular, the fixed-slit filler material 230c) to naturally melt and flow toward the fixed slit 221a, thereby removing the necessity of a separate sealing member and providing the advantages of reducing assembly man-hours, preventing an increase in the weight of a product, and reducing product costs.

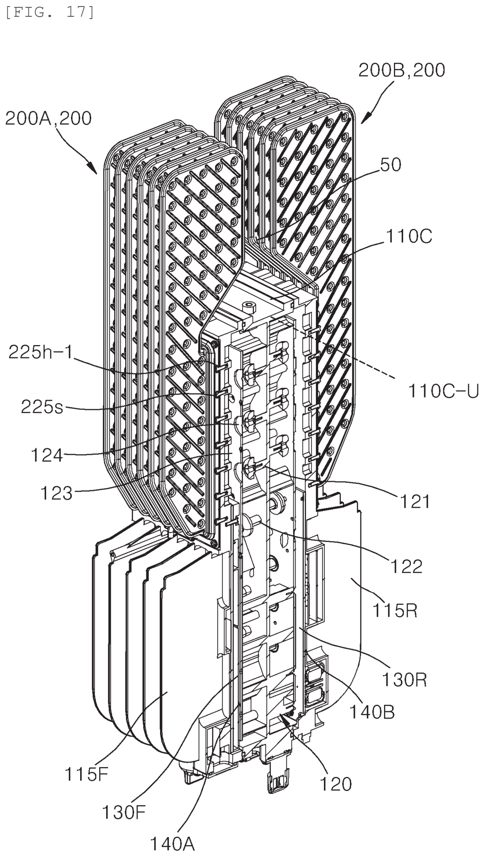

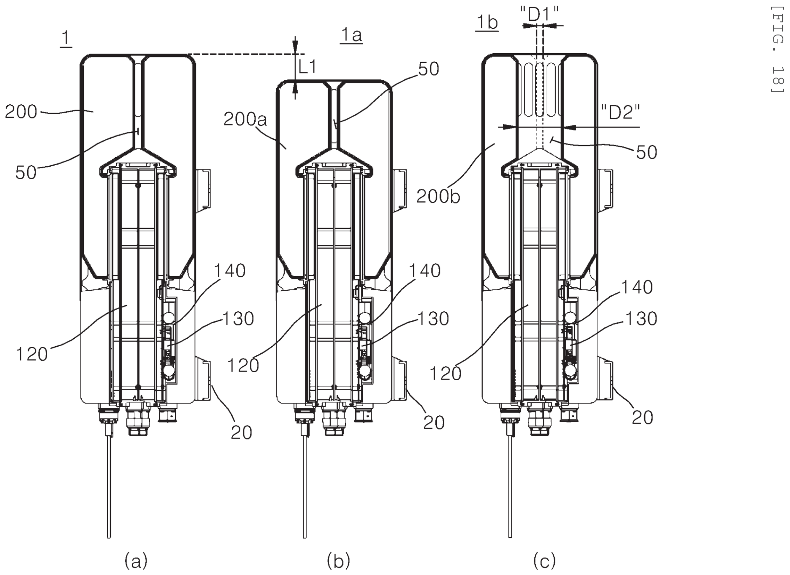

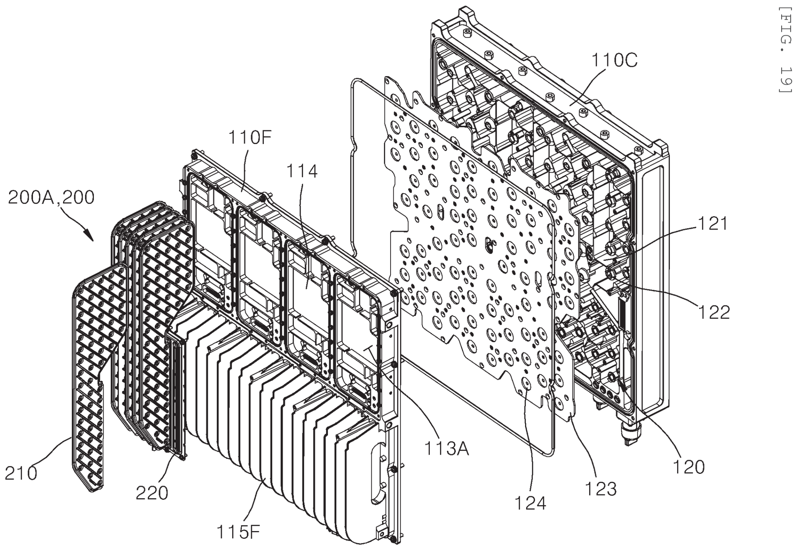

FIG. 17 is a cutaway perspective view taken along line A-A in FIG. 2, FIG. 18 is a cross-sectional view taken along line A-A in FIG. 2, and is a cross-sectional view showing various implementation examples of heat dissipation devices and heat dissipation modules, and FIG. 19 is an exploded perspective view showing the installation state of a front heat dissipation housing, the heat dissipation device, and a front heat dissipation module to the center housing of components of FIG. 1.

Referring to FIGS. 17 to 19, the heat discharging part 212 among the components of the heat dissipation device 210 can extend upward beyond an upper end 110C-U of the center housing 110C among the components the housing body 100, and can be extend to occupy at least the heat exchange region 50 corresponding to the upper part of the housing body 100 in the front-rear thickness direction. The direction in which the heat discharging part 212 extends may be the upper or lower end of the rim end of the housing body 100, as well as the left and right end of the rim end of the housing body 100.

In such a case, the outer end of the heat discharging part 212 can be provided to have a protrusion amount that matches the outer ends of the plurality of heat dissipation fins 115F and 115R formed at each of the front heat dissipation housing 110F and the rear heat dissipation housing 110R. The inner end of the heat discharging part 212 can extend to increase in area so as to occupy the heat exchange region 50 corresponding to the front-rear thickness direction of the housing body 100, starting from a portion where a rim end 212a to be described below is formed.

Since the heat exchange region 50 is a region protected from the outside by the finger guard panel assembly 10 and the flow of outside air may be limited, an outside air flow fan (not illustrated) may be provided inside the heat exchange region 50. Although not illustrated, the outside air flow fan is preferably installed in the heat exchange region 50 between the heat discharging parts 212 of the heat dissipation devices 210 installed in the front heat dissipation housing 110F and the rear heat dissipation housing 110R.

In this way, when a plurality of heat dissipation devices 210 according to an embodiment of the present disclosure are coupled to the front and rear portions of the housing body 100 as the front heat dissipation module 200A and the rear heat dissipation module 200B, the rear end of the heat discharging part 212 of the heat dissipation device 210 installed at the front portion of the front heat dissipation housing 110F and the front end of the heat discharging part 212 of the heat dissipation device 210 installed on the rear portion of the rear heat dissipation housing 110R can be disposed to have a predetermined separation distance (see reference numerals 'D1 and D2' in FIG. 18) in the front-rear direction with the heat exchange region 50 interposed therebetween.

As illustrated in (a) and (b) of FIG. 18, the upward extension length of the heat discharging part 212 from the upper end 110C-U of the center housing 110C of the housing body 100 is designed differently depending on the heat generation amount of the heating substance. However, for example, when the heat generation amount of the heating substance is relatively low, the extension length can be designed to be reduced by "L1". That is, the separation distance between the extended tip of the heat discharging part 212 and the rim end of the housing body 100 can be designed differently depending on the amount of heat generated by the heating substance.

As illustrated in (c) of FIG. 18, the inner ends of the heat discharging parts 212 of the heat dissipation devices 210 provided in the front heat dissipation housing 110F and the rear heat dissipation housing 110R can be designed so that the mutual separation distance therebetween is extended from "D1" to "D2".

To this end, the heat discharging part 212 may have the rim end 212a bent at a predetermined angle from the heat receiving part 211 to occupy the heat exchange region 50.

In this way, the heat dissipation device 210 according to an embodiment of the present disclosure includes the heat discharging part 212 extending to the heat exchange region 50 on the outer side of the rim end of the housing body 100 provided with the heating substance subjected to heat dissipation or the heat transfer member 221 for coupling so as to reduce interference of rising airflow during heat dissipation and enable more sufficient heat exchange of the extended portion with outside air in the heat exchange region 50, thereby providing the advantage of improving overall heat dissipation performance.

This provides the advantage of being able to design the heat dissipation device 210 to respond by changing the size and shape of the heat discharging part 212 according to the heat generation amount of the heating substance, or the like, without changing the radio unit 1 manufactured to a preset size.

In addition, the heat discharging part 212 can be manufactured with a differentiated design in outer shape and extended length in consideration of the heat generation amount of the heating substance, and easy application to a product is possible according to the specifications of the heating substance through modular manufacturing, thereby improving design diversity.

The heat dissipation device according to an embodiment of the present disclosure has been described in detail with reference to the attached drawings. However, the embodiments of the present disclosure are not necessarily limited to the above-described embodiments. It will be appreciated that various modifications and equivalent implementations are possible by those skilled in the art. Therefore, the true scope of the present disclosure is defined by the claims set forth below.

### [Industrial Applicability]

The present disclosure provides a heat dissipation device, a heat dissipation module, and an antenna apparatus including the same, which can improve on-site workability by preventing an increase in the weight and volume of an antenna unit requiring directivity adjustment while effectively dissipating heat generated from an electronic device such as an antenna apparatus.

## Claims

1. A heat dissipation device comprising:
heat receiving parts that collect heat generated from heating substances; and
a heat discharging part that exchanges heat collected from the heating substances with outside air,
wherein at least one of the heat receiving parts is coupled through a heat collection part, and is coupled to a housing body provided with the heating substances, and
the heat collection part comprises:
a heat transfer member for coupling formed with a plurality of fixed slits into which a part of at least one of the heat receiving parts is inserted; and
a shielding cover coupled to the heat transfer member for coupling to form a predetermined refrigerant-filled space therein, and sealing the refrigerant-filled space.

2. The heat dissipation device of claim 1, wherein the heat transfer member for coupling and the shielding cover seal the refrigerant-filled space during joining in a state in which the part of at least one of the heat receiving parts is inserted into the plurality of fixed slits.

3. The heat dissipation device of claim 2, wherein the joining is performed using any one of a brazing welding method and a laser welding method.

4. The heat dissipation device of claim 1, wherein the heat collection part further comprises:
a plurality of support pins each having one end supported by the shielding cover and the other end supported between adjacent fixed slits among the plurality of fixed slits adjacent to each other.

5. The heat dissipation device of claim 2, wherein a filler metal is applied to the heat transfer member for coupling along an inner end of the fixed slit,
flows in a direction of gravity when joining is performed by the brazing welding method, and seals a gap between the fixed slit and an outer side of the heat receiving part.

6. The heat dissipation device of claim 2, wherein the heat transfer member for coupling is provided with a plurality of rigid reinforcing dot portions protruding toward the shielding cover along a gap between the fixed slits,
the shielding cover is provided with a plurality of welding dot portions that protrude toward the heat transfer member for coupling at locations corresponding to the plurality of rigid reinforcing dot portions, and
during joining by the brazing welding method, the plurality of rigid reinforcing dot portions and the plurality of welding dot portions are joined together by a filler metal applied to the plurality of rigid reinforcing dot portions.

7. The heat dissipation device of claim 5 or 6, wherein the filler metal is further applied along a rim end of the heat transfer member for coupling in addition to the fixed slit or the rigid reinforcing dot portion.

8. The heat dissipation device of claim 5 or 6, wherein the filler metal is provided in a paste type or an alloy type with nickel as a main component.

9. The heat dissipation device of claim 2, wherein the filler metal is applied in advance to an inner end of the fixed slit in a state in which a part of the heat receiving part is inserted into the fixed slit.

10. A heat dissipation module comprising:
a heat dissipation device including heat receiving parts that collect heat generated from heating substances and a heat discharging part that exchanges heat collected from the heating substances with outside air; and
a heat collection part including a heat transfer member for coupling having one surface formed with a board receiving part for accommodating a PA board and the other surface formed with a plurality of fixed slits for installing the heat dissipation device, the heat transfer member for coupling being filled with phase-changeable refrigerant,
wherein the heat collection part comprises:
a heat transfer member for coupling formed with a plurality of fixed slits into which a part of at least one of the heat receiving parts is inserted; and
a shielding cover coupled to the heat transfer member for coupling to form a predetermined refrigerant-filled space therein, and sealing the refrigerant-filled space.

11. The heat dissipation module of claim 10, wherein the heat transfer member for coupling and the shielding cover seal the refrigerant-filled space during joining in a state in which the part of at least one of the heat receiving parts is inserted into the plurality of fixed slits.

12. The heat dissipation module of claim 11, wherein the heat transfer member for coupling is provided with a plurality of rigid reinforcing dot portions protruding toward the shielding cover along a gap between the fixed slits,
the shielding cover is provided with a plurality of welding dot portions that protrude toward the heat transfer member for coupling at locations corresponding to the plurality of rigid reinforcing dot portions, and
during joining by the brazing welding method, the plurality of rigid reinforcing dot portions and the plurality of welding dot portions are joined together by a filler metal applied to the plurality of rigid reinforcing dot portions.

13. An antenna apparatus comprising:
a housing body formed with an installed space where an RF filter unit is installed; and
a heat dissipation module coupled to a front portion or a rear portion of the housing body,
wherein the heat dissipation module comprises:
a heat dissipation device including heat receiving parts that collect heat generated from heating substances and a heat discharging part that exchanges heat collected from the heating substances with outside air; and
a heat collection part including a heat transfer member for coupling having one surface formed with a board receiving part for accommodating a PA board and the other surface formed with a plurality of fixed slits for installing the heat dissipation device, the heat transfer member for coupling being filled with phase-changeable refrigerant,
wherein the heat collection part comprises:
a heat transfer member for coupling formed with a plurality of fixed slits into which a part of at least one of the heat receiving parts is inserted; and
a shielding cover coupled to the heat transfer member for coupling to form a predetermined refrigerant-filled space therein, and sealing the refrigerant-filled space.

14. The antenna apparatus of claim 13, wherein the housing body comprises:
a center housing formed with the installation space where the RF filter unit is installed;
a front heat dissipation housing coupled to a front portion of the center housing; and
a rear heat dissipation housing coupled to a rear portion of the center housing,
wherein the heat dissipation module includes a front heat dissipation module installed at the front heat dissipation housing and a rear heat dissipation module installed at the rear heat dissipation housing, and
the front heat dissipation housing and the rear heat dissipation housing are each formed with a plurality of module coupling grooves that facilitate coupling of the front heat dissipation module and the rear heat dissipation module.

15. The antenna apparatus of claim 14, wherein, when the heat receiving part is disposed to overlap a front portion or a rear portion of the housing body in a front-rear direction, the heat discharging part of each of the front heat dissipation module and the rear heat dissipation module extends upward beyond an upper end of the housing body, and extends to occupy at least a part of a heat exchange region corresponding to a direct upper part of the housing body in a front-rear thickness direction.

16. The antenna apparatus of claim 14, wherein an upper end of the housing body further includes a guide panel formed with a plurality of guide slits into which upper ends of the heat dissipation devices of the front heat dissipation module and the rear heat dissipation module are inserted.
